(19) Europäisches Patentamt
European Patent Office
Office européen des brevets

(11) EP 4 692 937 A1

(12) EUROPEAN PATENT APPLICATION
published in accordance with Art. 153(4) EPC

(43) Date of publication:
**11.02.2026 Bulletin 2026/07**

(21) Application number: **24779939.8**

(22) Date of filing: **22.03.2024**

(51) International Patent Classification (IPC):
*G03F 7/037* (2006.01) *C08G 59/22* (2006.01)
*C08G 73/10* (2006.01) *C08K 5/1515* (2006.01)
*C08K 5/1525* (2006.01) *C08L 79/08* (2006.01)
*G03F 7/004* (2006.01) *G03F 7/20* (2006.01)

(52) Cooperative Patent Classification (CPC):
**C08G 59/22; C08G 73/10; C08K 5/1515; C08K 5/1525; C08L 79/08; G03F 7/004; G03F 7/037; G03F 7/20**

(86) International application number:
**PCT/JP2024/011242**

(87) International publication number:
**WO 2024/203821 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023057258**

(71) Applicant: **Toray Industries, Inc.**
**Tokyo 103-8666 (JP)**

(72) Inventors:
- **SAKAI, Tomoki**
  **Otsu-shi, Shiga 520-8558 (JP)**
- **OKUDA, Yumiko**
  **Otsu-shi, Shiga 520-8558 (JP)**
- **ARAKI, Hitoshi**
  **Otsu-shi, Shiga 520-8558 (JP)**

(74) Representative: **Kador & Partner Part mbB**
**Corneliusstraße 15**
**80469 München (DE)**

# (54) NEGATIVE PHOTOSENSITIVE RESIN COMPOSITION, CURED PRODUCT AND METHOD FOR PRODUCING SAME, HOLLOW STRUCTURE, ELECTRONIC COMPONENT, AND ELASTIC WAVE FILTER

(57) The present invention has been devised with a challenge to provide a negative photosensitive resin composition capable of affording a cured product superior in low residual stress and low water absorption. The present invention is a negative photosensitive resin composition including: a polyimide resin (A) containing one or more skeletons selected from the group consisting of an alkyleneoxy skeleton, a siloxane skeleton, and an aliphatic hydrocarbon skeleton having a linear structure; a cationically polymerizable compound (B); and a cationic polymerization initiator (C).

EP 4 692 937 A1

## Description

### TECHNICAL FIELD

The present invention relates to a negative photosensitive resin composition, a cured product and a method for producing the same, a hollow structure, an electronic component, and an acoustic wave filter. More specifically, the present invention relates to a negative photosensitive resin composition to be used suitably for surface protective films or interlayer insulating films in electronic components, structures of microelectromechanical systems (MEMS), and the like.

### BACKGROUND ART

Conventionally, polyimide-based materials and polybenzoxazole-based materials excellent in heat resistance, electrical insulation, and mechanical characteristics have been widely used for the surface protective films and the interlayer insulating films in semiconductor elements. Along with the recent demand for higher density and higher performance of semiconductor elements, materials having photosensitivity have been required for the surface protective films and the interlayer insulating films from the viewpoint of production efficiency.

Conventionally, polyimide-based materials, polybenzoxazole-based materials, and the like excellent in heat resistance, electrical insulation, and mechanical characteristics have been widely used for the surface protective films and the interlayer insulating films in electronic components.

Along with the recent demand for higher performance of electronic components, fine patterns and processing at a high aspect ratio are required for surface protective films and interlayer insulating films. To meet such demands, chemical amplification type cationically curable photosensitive resins are disclosed (for example, Patent Document 1). In addition, there is disclosed a photocationically curable photosensitive resin with which improve mechanical characteristics and heat resistance are intended to be improved by inclusion of an epoxy resin having a specific structure (for example, Patent Document 2).

### PRIOR ART DOCUMENT

### PATENT DOCUMENTS

Patent Document 1: International Publication No. 2008/007764
Patent Document 2: Japanese Patent Laid-open Publication No. 2019-38964

### SUMMARY OF THE INVENTION

### PROBLEMS TO BE SOLVED BY THE INVENTION

Along with the recent demand for miniaturization of electronic components, it is required to reduce the residual stress of surface protective films and interlayer insulating films in order to improve reliability. However, photocationically polymerizable materials like those described above have been difficult to achieve both processing at a high aspect ratio and low residual stress. In addition, photocationically polymerizable materials like those described above have a problem that their cured films have high water absorption, and their residual stress greatly varies due to moisture absorption or drying.

An object of the present invention is to provide a negative photosensitive resin composition capable of affording a cured product superior in low residual stress and low water absorption.

### SOLUTIONS TO THE PROBLEMS

To solve the problem described above, the present invention and preferred aspects thereof have the following configurations.

[1] A negative photosensitive resin composition comprising: a polyimide resin (A) containing one or more skeletons selected from the group consisting of an alkyleneoxy skeleton, a siloxane skeleton, and an aliphatic hydrocarbon skeleton containing a linear structure; a cationically polymerizable compound (B); and a cationic polymerization initiator (C).

[2] The negative photosensitive resin composition according to [1], wherein the polyimide resin (A) contains an

aliphatic hydrocarbon skeleton containing a linear structure, and the aliphatic hydrocarbon skeleton containing a linear structure contains a dimer acid derivative skeleton.

[3] The negative photosensitive resin composition according to [2], wherein the dimer acid derivative skeleton contains a dimer diamine skeleton, and a content of a dimer diamine residue in a total amount of 100 mol% of all diamine residues in the polyimide resin (A) is 3 mol% or more and 20 mol% or less.

[4] The negative photosensitive resin composition according to any one of [1] to [3], wherein the polyimide resin (A) contains an alkyleneoxy skeleton, and

the alkyleneoxy skeleton is a skeleton represented by formula (1):

[Chemical Formula 1]

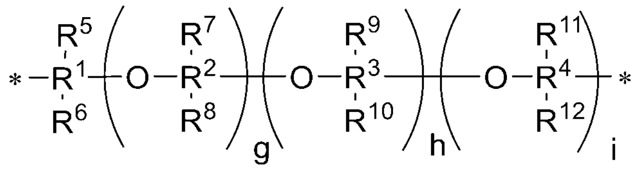
(1)

in the formula (1), $R^1$ to $R^4$ each independently represent an alkylene group having 1 to 6 carbon atoms; $R^5$ to $R^{12}$ each independently represent a hydrogen atom, a fluorine atom, or an alkyl group having 1 to 6 carbon atoms; parenthesized structures are different from each other; g, h, and i each independently represent an integer of 0 to 35, and $g + h + i > 0$; each symbol * represents a bonding site.

[5] The negative photosensitive resin composition according to any one of [1] to [4], wherein a content of fluorine atoms in 100% by mass of the negative photosensitive resin composition excluding a solvent is 0.0% by mass or more and 3.0% by mass or less.

[6] The negative photosensitive resin composition according to any one of [1] to [5], wherein a ratio Y/X of an amount Y (mol) of all diamine residues to an amount X (mol) of all carboxylic acid residues contained in the polyimide resin (A) is 0.80 to 0.95.

[7] The negative photosensitive resin composition according to any one of [1] to [6], wherein the cationically polymerizable compound (B) contains an epoxy compound and/or an oxetane compound.

[8] The negative photosensitive resin composition according to [7], wherein the oxetane compound contains an oxetane compound (B1) represented by formula (8):

[Chemical Formula 2]

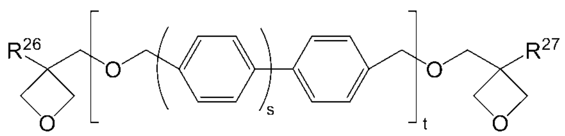
(8)

in the formula (8), s and t each independently represent an integer of 0 to 6, and $R^{26}$ and $R^{27}$ each independently represent a monovalent organic group having 1 to 5 carbon atoms.

[9] The negative photosensitive resin composition according to [7] or [8], wherein the epoxy compound contains an epoxy compound (B2) represented by formula (9):

[Chemical Formula 3]

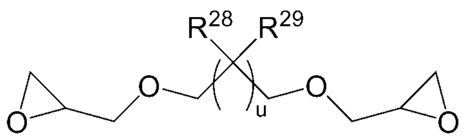
(9)

in the formula (9), u represents an integer of 1 to 5, and $R^{28}$ and $R^{29}$ each independently represent a hydrogen atom, a methyl group, or a group represented by formula (10) :

[Chemical Formula 4]

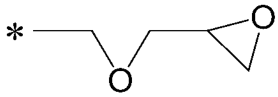 (10)

in the formula (10), the symbol * represents a bonding site.

[10] The negative photosensitive resin composition according to any one of [7] to [9], wherein the cationically polymerizable compound (B) contains the epoxy compound and the oxetane compound, and an amount of the epoxy compound based on 100 parts by mass of the oxetane compound is 10 to 250 parts by mass.

[11] The negative photosensitive resin composition according to any one of [1] to [10], further comprising a methylol-based crosslinking agent (D).

[12] The negative photosensitive resin composition according to [11], wherein the methylol-based crosslinking agent (D) contains a compound (D1) represented by formula (11):

[Chemical Formula 5]

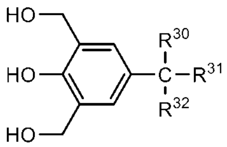 (11)

in the formula (11), $R^{30}$, $R^{31}$ and $R^{32}$ each independently represent a hydrogen atom, a methyl group, or a group represented by formula (12):

[Chemical Formula 6]

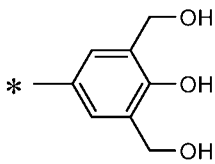 (12)

in the formula (12), the symbol * represents a bonding site.

[13] The negative photosensitive resin composition according to any one of [1] to [12], wherein the cationic polymerization initiator (C) contains a sulfonium salt containing at least one selected from the group consisting of a borate ion, a phosphate ion, and a gallate ion as a counter anion.

[14] A cured product that is derived from the negative photosensitive resin composition according to any one of [1] to [13].

[15] A method for producing a cured product, the method comprising:

a step of applying the negative photosensitive resin composition according to any one of [1] to [13] onto a substrate, and drying the negative photosensitive resin composition to form a photosensitive resin film on the substrate;

a step of exposing the photosensitive resin film to light;

a step of removing an unexposed portion of the photosensitive resin film with an alkali aqueous solution to develop the photosensitive resin film; and

a step of heat-treating the developed photosensitive resin film to form a cured product.

[16] A hollow structure comprising a support material containing the cured product according to [14].

[17] An electronic component comprising the cured product according to [14].

[18] The electronic component according to [17], wherein the cured product has a residual stress under a dry nitrogen atmosphere of 15 to 35 MPa.

[19] An acoustic wave filter comprising the cured product according to [14], wherein the cured product has a residual stress under a dry nitrogen atmosphere of 15 to 35 MPa.

EFFECTS OF THE INVENTION

Using the negative photosensitive resin composition of the present invention, it is possible to obtain a cured product superior in low residual stress and low water absorption.

EMBODIMENTS OF THE INVENTION

The negative photosensitive resin composition of the present invention contains a polyimide resin (A), a cationically polymerizable compound (B), and a cationic polymerization initiator (C).

It is important that the polyimide resin (A) contains one or more skeletons selected from the group consisting of an alkyleneoxy skeleton, a siloxane skeleton, and an aliphatic hydrocarbon skeleton containing a linear structure. Owing to containing these skeletons, a resulting cured film has lowered water absorption, high elongation in the cured film is obtained, and residual stress can be relaxed.

When the polyimide resin (A) contains the alkyleneoxy skeleton, more preferably a skeleton represented by the following formula (1), compatibility with the cationically polymerizable compound (B) is improved, and solubility during development is improved, so that generation of residues can be reduced.

[Chemical Formula 7]

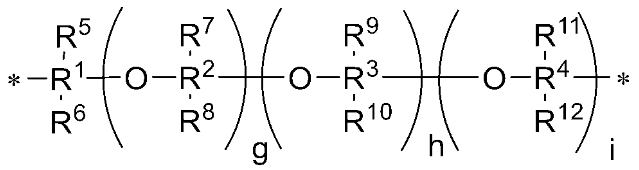

(1)

In the formula (1), $R^1$ to $R^4$ each independently represent an alkylene group having 1 to 6 carbon atoms. $R^5$ to $R^{12}$ each independently represent a hydrogen atom, a fluorine atom, or an alkyl group having 1 to 6 carbon atoms. Parenthesized structures are different from each other. g, h, and i each independently represent an integer of 0 to 35, and g + h + i > 0. The symbol * represents a bonding site.

Examples of the alkyleneoxy skeleton represented by the formula (1) include a skeleton containing a structure derived from ethylene oxide, a skeleton containing a structure derived from propylene oxide, and a skeleton containing a structure derived from butylene oxide, and these skeletons may be contained singly or two or more of them may be contained in combination.

Preferably, the polyimide resin (A) contains a skeleton represented by the formula (1) and has an alkyleneoxy equivalent of $4 \times 10^3$ g/mol or more and $45 \times 10^3$ g/mol or less. Herein, the alkyleneoxy equivalent refers to the mass of the polyimide resin (A) per mole of the skeleton represented by the formula (1). When the alkyleneoxy equivalent is $4 \times 10^3$ g/mol or more, good photosensitivity is easily obtained. When the alkyleneoxy equivalent is $45 \times 10^3$ g/mol or less, it is easy to effectively improve residual stress and solubility during development.

Furthermore, the polyimide resin (A) preferably contains a diamine residue having a skeleton represented by the formula (1). Examples of commercially available diamines having an alkyleneoxy skeleton represented by the formula (1) include ED-600, ED-900, ED-2003, EDR-148, EDR-176, D-200, D-400, D-2000, THF-100, THF-140, THF-170, RE-600, RE-900, RE-2000, RP-405, RP-409, RP-2005, RP-2009, RT-1000, HE-1000, HT-1100, and HT-1700 (trade names, manufactured by HUNTSMAN Corporation).

The content of the diamine residue having a skeleton represented by the formula (1) is preferably 2 mol% or more and 15 mol% or less based on 100 mol% of the total amount of all diamine residues in the polyimide resin (A). When the content is 2 mol% or more, residual stress and solubility during development can be effectively improved. When the content is 15 mol% or less, good photosensitivity can be obtained.

Examples of the siloxane skeleton contained in the polyimide resin (A) include a siloxane skeleton represented by the following formula (2).

[Chemical Formula 8]

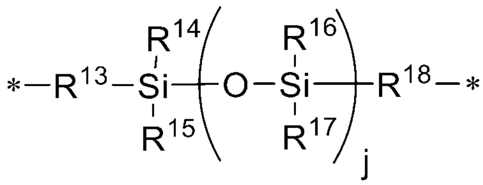
(2)

In the formula (2), j represents an integer of 1 to 40. $R^{13}$ and $R^{18}$ each independently represent an alkylene group having 1 to 15 carbon atoms. $R^{14}$ to $R^{17}$ each independently represent an alkyl group having 1 to 15 carbon atoms or an aryl group having 6 to 10 carbon atoms. Each symbol * represents a bonding site.

Examples of the aliphatic hydrocarbon skeleton containing a linear structure contained in the polyimide resin (A) include an alkylene group and an alicyclic skeleton containing an alkylene group.

The alkylene group preferably has 5 to 40 carbon atoms. When the number of carbon atoms is 5 or more, an enhanced effect of reducing the water absorption and residual stress of the resulting cured film is obtained, and when the number of carbon atoms is 40 or less, developability is easily secured. The alkylene group may be formed of only a linear chain, or may have a branch point and have an alkyl group as a side chain. Further, the alkylene group may have a plurality of branch points. The alkyl group as the side chain preferably has 1 to 20 carbon atoms, and may be either linear or branched.

In an alicyclic skeleton containing an alkylene group, the alkylene group preferably has 3 to 30 carbon atoms, and the alicyclic skeleton preferably has 4 to 60 carbon atoms. Examples thereof include an alicyclic skeleton containing an alkylene group represented by the following formula (3) or formula (4).

[Chemical Formula 9]

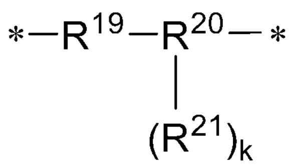
(3)

In the formula (3), $R^{19}$ represents an alkylene group having 3 to 20 carbon atoms. $R^{20}$ represents a cyclic structure having 4 to 30 carbon atoms. Multiple $R^{21}$s each independently represent a hydrogen atom or an alkyl group having 1 to 20 carbon atoms. k represents an integer of 0 to 28. Each symbol * represents a bonding site.

[Chemical Formula 10]

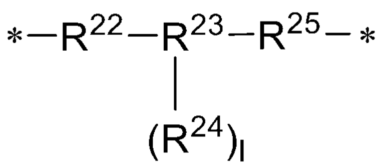
(4)

In the formula (4), $R^{22}$ and $R^{25}$ each independently represent an alkylene group having 3 to 20 carbon atoms. $R^{23}$ represents a cyclic structure having 4 to 30 carbon atoms. Multiple $R^{24}$s each independently represent a hydrogen atom or an alkyl group having 1 to 20 carbon atoms. l represents an integer of 0 to 28. Each symbol * represents a bonding site.

Examples of the polyimide resin include those obtained through a reaction of a tetracarboxylic acid and a derivative thereof with a diamine and a derivative thereof by heating or by using an acid, a base, or the like. Examples of the polyimide resin include polyimide, polyamideimide, and polyetherimide, and their precursors may be contained. In the present invention, it is important that a polyimide resin containing one or more skeletons selected from the group consisting of an alkyleneoxy skeleton, a siloxane skeleton, and an aliphatic hydrocarbon skeleton containing a linear structure is contained, and as long as the polyimide resin containing one or more skeletons selected from the group consisting of an alkyleneoxy skeleton, a siloxane skeleton, and an aliphatic hydrocarbon skeleton containing a linear structure is contained, other polymer compounds may be contained. By using a compound containing at least one skeleton selected from the group consisting of an alkyleneoxy skeleton, a siloxane skeleton, and an aliphatic hydrocarbon skeleton containing a linear structure as at least one of a tetracarboxylic acid, a derivative thereof, a diamine, and a derivative

thereof, a polyimide resin containing these skeletons is obtained.

Examples of a diamine having a siloxane skeleton specifically include bis(3-aminopropyl)tetramethyldisiloxane, bis(p-aminophenyl)octamethylpentasiloxane, PAM-E, KF-8010, X-22-161A, X-22-161B, KF-8012, KF-8008, X-22-1660B-3, and X-22-9409 (trade names, manufactured by Shin-Etsu Chemical Co., Ltd.).

Examples of a commercially available acid dianhydride having a siloxane skeleton include X-22-168AS, X-22-168A, X-22-168B, and X-22-168-P5-B (trade names, manufactured by Shin-Etsu Chemical Co., Ltd.).

The polyimide resin (A) preferably contains an aliphatic hydrocarbon skeleton having a linear structure. It is preferable that the aliphatic hydrocarbon skeleton containing a linear structure be contained in that the influence on photosensitivity and storage stability is small and the residual stress of a cured film can be reduced. In addition, it is more preferable that a dimer acid derivative skeleton be contained in that water absorption can be reduced.

Examples of a diamine having an aliphatic hydrocarbon skeleton containing a linear structure include diamines having a linear alkylene group, such as ethylenediamine, trimethylenediamine, tetramethylenediamine, pentamethylenediamine, hexamethylenediamine, heptamethylenediamine, and octamethylenediamine; diamines having a branched alkylene group, such as propylenediamine, 2-methyl-1,5-pentamethylenediamine, and 2-methyl-1,8-octanediamine; and diamines having a dimer acid derivative skeleton described later.

Examples of an acid anhydride having an aliphatic hydrocarbon skeleton containing a linear structure include ester compounds such as ethylene glycol bistrimellitate dianhydride, tetramethylene bistrimellitate dianhydride, pentamethylene bistrimellitate dianhydride, hexamethylene bistrimellitate dianhydride, heptamethylene bistrimellitate dianhydride, octamethylene bistrimellitate dianhydride, nonamethylene bistrimellitate dianhydride, decamethylene bistrimellitate dianhydride, dodecamethylene bistrimellitate dianhydride, tetradecamethylene bistrimellitate dianhydride, hexadecamethylene bistrimellitate dianhydride, and octadecamethylene bistrimellitate dianhydride; amide compounds such as tetraethylene bistrimellitic acid amide dianhydride, pentamethylene bistrimellitic acid amide dianhydride, hexamethylene bistrimellitic acid amide dianhydride, heptamethylene bistrimellitic acid amide dianhydride, octamethylene bistrimellitic acid amide dianhydride, nonamethylene bistrimellitic acid amide dianhydride, decamethylene bistrimellitic acid amide dianhydride, dodecamethylene bistrimellitic acid amide dianhydride, tetradecamethylene bistrimellitic acid amide dianhydride, hexadecamethylene bistrimellitic acid amide dianhydride, and octadecamethylene bistrimellitic acid amide dianhydride; and acid dianhydrides having a dimer acid derivative skeleton described later.

Examples of a commercially available diamine having a dimer acid derivative skeleton include Versamine (registered trademark) 551, Versamine (registered trademark) 552 (manufactured by BASF), Priamine (registered trademark) 1073, Priamine (registered trademark) 1074, and Priamine (registered trademark) 1075 (manufactured by Croda Japan KK). In addition, a mixture of a trimer triamine and a dimer diamine may be used, and examples of a commercially available product include Priamine (registered trademark) 1071 (manufactured by Croda Japan KK).

Examples of the acid dianhydride having a dimer acid derivative skeleton include reaction products of the dimer diamines recited above as examples with trimellitic anhydride chloride. More specifically, the acid dianhydride having a dimer acid derivative skeleton is represented by the following formula (5).

[Chemical Formula 11]

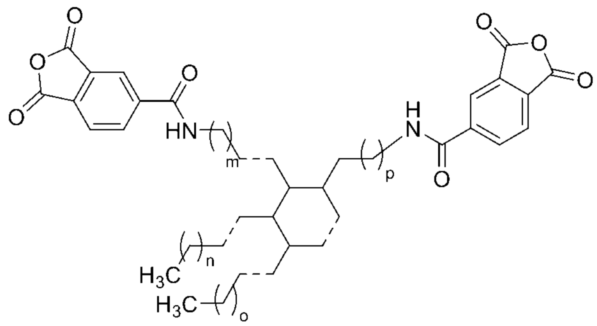

(5)

In the formula (5), m, n, o, and p are natural numbers, m + n = 6 to 17, and o + p = 8 to 19. A broken line part means a carbon-carbon single bond or a carbon-carbon double bond.

The dimer acid derivative skeleton preferably contains a dimer diamine skeleton. The content of the dimer diamine residue in 100 mol% of the total amount of all diamine residues in the polyimide resin (A) is preferably 3 mol% or more and 20 mol% or less. When the content of the dimer diamine residue is 3 mol% or more, the water absorption and residual stress of a cured film can be more effectively reduced. When the content of the dimer diamine residue is 20 mol% or less, the influence on photosensitivity, resolution, and exposure margin can be controlled.

The weight average molecular weight of the polyimide resin (A) is preferably 1,000 or more and 200,000 or less

from the viewpoint of the viscosity and patterning property of the resulting resin composition. The weight average molecular weight is more preferably 3,000 or more and 100,000 or less, and even more preferably 5,000 or more and 50,000 or less. The polyimide resin in the polyimide resin (A) may be a single resin used, or may be a combination of two or more polyimide resins used. The weight average molecular weight of a polyimide resin in the polyimide resin (A) in the present invention is measured by gel permeation chromatography (a GPC method) and calculated in terms of polystyrene.

It is preferable that the content of the polyimide resin (A) be 40 parts by mass or more and 300 parts by mass or less based on 100 parts by mass of the cationically polymerizable compound (B) in obtaining good processability, mechanical characteristics, and heat resistance. When the content of the polyimide resin (A) is 40 parts by mass or more, more preferably 50 parts by mass or more, and even more preferably 60 parts by mass or more with respect to 100 parts by mass of the cationically polymerizable compound (B), the negative photosensitive resin composition is superior in heat resistance. In addition, when the content of the polyimide resin (A) is 300 parts by mass or less, more preferably 200 parts by mass or less, and even more preferably 120 parts by mass or less with respect to 100 parts by mass of the cationically polymerizable compound (B), the negative photosensitive resin composition is superior in storage stability, photosensitivity, and low residual stress.

The polyimide resin (A) is preferably an alkali-soluble polymer compound. When the polyimide resin (A) is alkali-soluble, development can be performed using an alkali aqueous solution in development during pattern processing without using an organic solvent that will cause an environmental load. The term "alkali-soluble" as used herein refers to a substance that dissolves in an amount of 0.1 g or more at 25°C with respect to 100 g of a 2.38% by mass aqueous solution of tetramethylammonium hydroxide. To exhibit alkali solubility, the polyimide resin (A) preferably has an alkali-soluble functional group.

The alkali-soluble functional group is a functional group having acidity, and examples thereof include a phenolic hydroxyl group, a carboxyl group, and a sulfonic acid group. Among the above-described alkali-soluble functional groups, a phenolic hydroxyl group is preferred in view of problems such as storage stability of the photosensitive resin composition composition and corrosion to copper wiring as a conductor.

It is preferable for the polyimide resin (A) to have a light transmittance per micrometer film thickness of 90% or more, more preferably 95% or more, and even more preferably 99% or more at a wavelength of 365 nm. Within this range, fine patterning property can be exhibited even in a thick film being 20 μm or more thick when the negative photosensitive resin composition is formed.

The carboxylic acid residue of the polyimide resin (A) is a residue derived from a carboxylic acid or a carboxylic acid derivative that can constitute the polyimide resin (A). The carboxylic acid residue of the polyimide resin (A) refers to, for example, a structure of a residue derived from a monocarboxylic acid, a dicarboxylic acid, a tetracarboxylic acid, an acid anhydride, an acid dianhydride, a monoacid chloride, a diacid chloride, or the like. Examples of the carboxylic acid or the carboxylic acid derivative include, but are not limited to, aromatic dicarboxylic acids, aromatic acid dianhydrides, alicyclic dicarboxylic acids, alicyclic acid dianhydrides, aliphatic dicarboxylic acids, aliphatic acid dianhydrides, siloxane-modified dicarboxylic acids, siloxane-modified acid dianhydrides, polyether dicarboxylic acids, and polyether acid dianhydrides. These may be used singly, or two or more thereof may be used in combination.

The diamine residue of the polyimide resin (A) is a residue derived from a diamine or a derivative thereof that can constitute the polyimide resin (A). The diamine residue of the polyimide resin (A) refers to, for example, a structure of a residue derived from a diamine, a diisocyanate, or the like. Examples of the diamine or a derivative thereof include, but are not limited to, aromatic diamines, aromatic diisocyanates, alicyclic diamines, alicyclic diisocyanates, aliphatic diamines, aliphatic diisocyanates, siloxane-modified diamines, siloxane-modified diisocyanates, polyether diamines, and polyether diisocyanates. These may be used singly, or two or more thereof may be used in combination.

The monoamine residue of the polyimide resin (A) is a residue derived from a monoamine or a derivative thereof that can constitute the polyimide resin (A). The monoamine residue of the polyimide resin (A) refers to, for example, a structure of a residue derived from a monoamine, a monoisocyanate, or the like. Examples of the monoamine or a derivative thereof include, but are not limited to, aromatic monoamines, aromatic monoisocyanates, alicyclic monoamines, alicyclic monoisocyanates, aliphatic monoamines, aliphatic monoisocyanates, siloxane-modified monoamines, siloxane-modified monoisocyanates, polyether monoamines, and polyether monoisocyanates. These may be used singly, or two or more thereof may be used in combination. The monoamine residue preferably has a crosslinkable functional group from the viewpoint of the heat resistance and the chemical resistance of a cured product. Examples of the crosslinkable functional group include, but are not limited to, a hydroxy group and an ethynyl group. Among the crosslinkable functional groups, a hydroxy group is preferred from the viewpoint of alkali solubility.

In the present invention, the polyimide resin (A) preferably has a structural unit represented by the following formula (6).

[Chemical Formula 12]

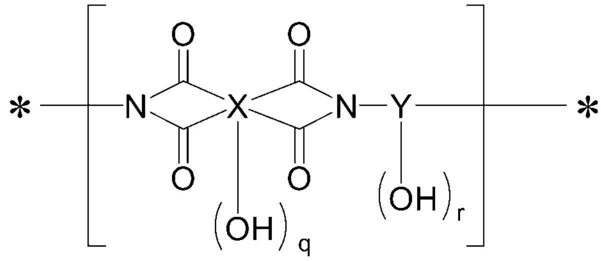

(6)

In the formula (6), X represents a 2- to 10-valent organic group, Y represents a 2- to 4-valent organic group, and q and r each independently represent an integer of 0 to 4. The symbol * represents a bonding point.

X in the formula (6) represents a carboxylic acid residue. Y represents a diamine residue.

The polyimide resin (A) preferably has a phenolic hydroxyl group, and in the polyimide resin (A), Y in the formula (6) more preferably contains a diamine residue having a phenolic hydroxyl group. When the diamine residue having a phenolic hydroxyl group is contained, moderate solubility of the resin in an alkaline developer can be obtained, and consequently, a high contrast between an exposed portion and an unexposed portion can be obtained, and a desired pattern can be formed.

Y in the formula (6) may contain a diamine residue having an aromatic ring other than the diamine residue having a phenolic hydroxyl group. Copolymerization of these is preferable in that heat resistance can be improved.

Examples of the diamine residue having an aromatic ring include, but are not limited to, aromatic diamines such as 3,4'-diaminodiphenyl ether, 4,4'-diaminodiphenyl ether, 3,4'-diaminodiphenyl methane, 4,4'-diaminodiphenyl methane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl, and compounds obtained by replacing some of hydrogen atoms of these aromatic rings and hydrocarbons by an alkyl group or a fluoroalkyl group having 1 to 10 carbon atoms, a halogen atom, or the like. The polyimide resin (A) may contain two or more of these diamine residues.

It is more preferable that the polyimide resin (A) contain a diamine residue represented by the following formula (7) in that solubility and heat resistance are improved.

[Chemical Formula 13]

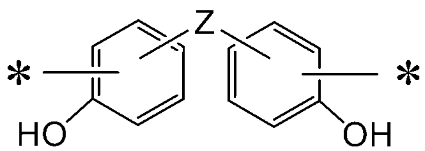

(7)

In the formula (7), Z represents a direct bond, an alkyl group or fluoroalkyl group having 1 to 10 carbon atoms, a fluorene group, or a sulfonyl group. Each symbol * represents a bonding site.

Examples of the diamine residue represented by the formula (7) include bis(3-amino-4-hydroxyphenyl)sulfone, 9,9-bis(3-amino-4-hydroxyphenyl)fluorene, bis(3-amino-4-hydroxyphenyl)methane, 1,1-bis(3-amino-4-hydroxyphenyl) ethane, 2,2-bis(3-amino-4-hydroxyphenyl)propane, and 2,2-bis(3-amino-4-hydroxyphenyl)hexafluoropropane. The polyimide resin (A) may contain two or more of these diamine residues.

It is also preferable that the polyimide resin (A) contain a hydroxydiamine residue. When the polyimide resin (A) contains a hydroxydiamine residue, more preferably one or more diamine residues selected from the group consisting of the diamine residues represented by the following formulas (13) to (15), heat resistance is further improved.

[Chemical Formula 14]

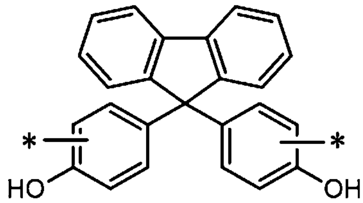

(13)

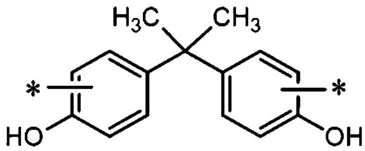

(14)

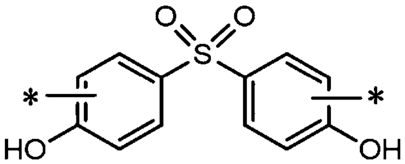

(15)

In the formulas (13) to (15), each symbol * represents a bonding site.

Furthermore, it is particularly preferable that the polyimide resin (A) contain a diamine residue represented by the formula (13). When the polyimide resin (A) contains the diamine residue represented by the formula (13), packing between polyimides is suppressed, and a residue is reduced.

The polyimide resin (A) preferably has an alicyclic structure. When the polyimide resin (A) has an alicyclic structure, the transparency of the resin composition is improved, and the patterning property is improved. In addition, it is more preferable that the polyimide resin (A) contain a carboxylic acid residue having an alicyclic structure from the viewpoint of improving the solubility of the resin composition. Furthermore, it is particularly preferable that the polyimide resin (A) be a carboxylic acid residue having a structure derived from an alicyclic tetracarboxylic dianhydride having a polycyclic structure in that chemical resistance to be exhibited when a cured product is formed is improved and ion migration resistance is improved.

Furthermore, as the carboxylic acid residue, a residue of an acid dianhydride other than the alicyclic tetracarboxylic dianhydride having a polycyclic structure may be contained. Specifically, examples thereof include, but are not limited to, residues of aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl) ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl) ether dianhydride, 1,2,5,6-naphthalenetetracarboxylic dianhydride, 9,9-bis(3,4-dicarboxyphenyl)fluorenic dianhydride, 9,9-bis{4-(3,4-dicarboxyphenoxy)phenyl}fluorenic dianhydride, 2,3,6,7-naphthalenetetracarboxylic dianhydride, 2,3,5,6-pyridinetetracarboxylic dianhydride, 3,4,9,10-perylenetetracarboxylic dianhydride, and 2,2-bis(3,4-dicarboxyphenyl)hexafluoropropane dianhydride; residues of 3,3',4,4'-diphenylsulfonetetracarboxylic dianhydride, 1,2,3,4-cyclobutanetetracarboxylic dianhydride, 1,2,3,4-cyclopentanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentanacetic dianhydride, and 2,3,4,5-tetrahydrofurantetracarboxylic dianhydride; and residues of compounds obtained by replacing some of the hydrogen atoms of these aromatic rings and hydrocarbons by an alkyl group or fluoroalkyl group

having 1 to 10 carbon atoms, a halogen atom, or the like. The polyimide resin (A) may contain two or more of these tetracarboxylic dianhydride residues.

Molecular chain terminals of the polyimide resin (A) are each preferably sealed with a monoamine residue. As a result of sealing molecular chain terminals of the polyimide resin (A) with a monoamine residue, an excessive reaction between carboxylic acid residues of the polyimide resin (A) and the cationically polymerizable compound (B) is suppressed, and an increase in viscosity when the negative photosensitive resin composition is stored at room temperature can be controlled. Examples of the monoamine residue include residues of 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 3-amino-4,6-dihydroxypyrimidine, 2-aminophenol, 3-aminophenol, 4-aminophenol, 2-aminothiophenol, 3-aminothiophenol, and 4-aminothiophenol; and residues of compounds obtained by replacing some of the hydrogen atoms of these aromatic rings and hydrocarbons by an alkyl group or fluoroalkyl group having 1 to 10 carbon atoms, a halogen atom, or the like. The polyimide resin (A) may contain two or more of these monoamine residues.

Where the total amount of all carboxylic acid residues contained in the polyimide resin (A) is designated as A mol, the total amount of diamine residues is designated as B mol, and the total amount of monoamine residues is designated as C mol, the polyimide resin (A) preferably satisfies the following relationship.

$$0.60 \leq (B + 0.5C)/A \leq 0.98$$

When (B + 0.5C)/A is 0.60 or more, more preferably 0.80 or more, and even more preferably 0.90 or more, the weight average molecular weight of the polyimide resin (A) tends to be 1,000 or more, and a cured product having good mechanical characteristics can be obtained. When (B + 0.5C)/A is 0.98 or less, it is possible to reduce the proportion of molecular chains having diamine residues at terminals, which can work to deactivate cations, photocationic polymerization easily proceeds, and good photocurability can be obtained.

In addition, the polyimide resin (A) preferably satisfies the following relationship with respect to the amounts A, B, and C.

$$0.05 \leq C/(B + C) \leq 0.25$$

When C/(B + C) is 0.05 or more, some of the molecular chain terminals of the polyimide resin (A) are sealed with a monoamine residue. As a result, an excessive reaction between carboxylic acid residues of the polyimide resin (A) and the cationically polymerizable compound (B) is suppressed, and an increase in viscosity when the negative photosensitive resin composition is stored at room temperature can be controlled. When C/(B+C) is 0.25 or less, more preferably 0.15 or less, and even more preferably 0.10 or less, the weight average molecular weight of the polyimide resin (A) tends to be 1,000 or more, and a cured product having good mechanical characteristics can be more effectively obtained.

The amounts of the carboxylic acid residue, the diamine residue, and the monoamine residue contained in the polyimide resin (A) can be detected by the following methods. For example, by dissolving the polyimide resin (A) in an acidic solution and analyzing the solution using gas chromatography (GC) or nuclear magnetic resonance (NMR), the carboxylic acid residue, the diamine residue, and the monoamine residue contained in the polyimide resin (A) can be detected, and the ratio thereof can be determined. In addition, by directly analyzing the negative photosensitive resin composition or the polyimide resin (A) using NMR or the like, the carboxylic acid residue, the diamine residue, and the monoamine residue contained in the polyimide resin (A) can be detected, and the ratio thereof can be determined. When the negative photosensitive resin composition is prepared using a polymerization liquid of the polyimide resin (A) without purification, the ratio of the carboxylic acid residue, the diamine residue, and the monoamine residue contained in the polyimide resin (A) matches the monomer feed ratio at the time of the polymerization to the polyimide resin (A), and thus can also be calculated from the monomer feed ratio at the time of the polymerization to the polyimide resin (A).

In the present invention, the contents of various carboxylic acid residues, diamine residues, monoamine residues, and dimer diamine residues and the alkyleneoxy equivalent are specified by the following method.

When the monomer feed ratio at the time of the polymerization to the polyimide resin (A) is known, the contents of the residues and the alkyleneoxy equivalent are calculated from the molecular weights and the feed ratio of the monomers.

When the monomer feed ratio at the time of the polymerization to the polyimide resin (A) is unknown, the negative photosensitive resin composition or the polyimide resin (A) is directly analyzed using 1H-NMR.

For more reliable identification and qualitative/quantitative determination of copolymerization components, the polyimide resin (A) is hydrolyzed with an alkali, and each monomer component after the hydrolysis is separated by an HPLC method. The substituent information of each fragment is analyzed by FT-IR, and the structural information is identified by 1H-NMR and 13C-NMR. When identification is difficult, GC/MS analysis is further performed to identify copolymerization components by combining mass information.

The ratio Y/X of the amount Y (mol) of all diamine residues to the amount X (mol) of all carboxylic acid residues contained in the polyimide resin (A) is preferably 0.80 to 0.95. When the ratio Y/X is 0.80 or more, the weight average molecular weight of the polyimide resin (A) is likely to be 10,000 or more, and the polyimide resin (A) is superior in heat resistance. In addition, when the ratio Y/X is 0.95 or less, the polyimide resin (A) is superior in alkali solubility, and the resolution can be further improved without lowering the photosensitivity during pattern processing.

In the present invention, the polyimide resin (A) is synthesized, for example, by the following method, but the method for synthesizing the polyimide resin (A) is not limited thereto. The polyimide resin (A) is obtained through a reaction of a tetracarboxylic acid and a derivative thereof with a diamine and a derivative thereof by heating or using an acid, a base, or the like.

In the present invention, it is preferable that the polyimide resin (A) be generated through polymerization by the above-described method, subsequently added into a plenty of water, a mixture of methanol and water, or the like to precipitate, and then collected by filtration and dried, thereby being isolated. The drying temperature is preferably 40 to 100°C, and more preferably 50 to 80°C. That operation is preferable in that unreacted monomers or oligomer components such as a dimer and a trimer are thereby removed, and the heat resistance, the chemical resistance, and the like of a cured product are improved.

The imidization ratio in the present invention can be easily determined, for example, by the following method. First, an infrared absorption spectrum of a polymer is measured, and the presence of absorption peaks (near 1780 $cm^{-1}$ and near 1377 $cm^{-1}$) of an imide structure derived from a polyimide is confirmed. Next, a material obtained by heat-treating the polymer at 350°C for 1 hour is used as a sample having an imidization ratio of 100%, an infrared absorption spectrum thereof is measured, and the content of imide groups in the resin before the heat treatment is calculated by comparing the intensities of the peak near 1377 $cm^{-1}$ of the resin before and after the heat treatment, and the imidization ratio is determined. The imidization ratio is preferably 50% or more, and more preferably 80% or more because a change in the ring-closing rate during thermal curing can be controlled and an effect of reducing residual stress can be obtained.

The negative photosensitive resin composition of the present invention contains a cationically polymerizable compound (B). Examples of the cationically polymerizable compound (B) include cyclic ether compounds, such as epoxy compounds and oxetane compounds, ethylenically unsaturated compounds, such as vinyl ethers and styrenes, episulfide compounds, bicyclo orthoesters, spiro orthocarbonates, and spiro orthoesters.

Publicly-known epoxy compounds and the like can be used as the epoxy compound, and examples thereof include an aromatic epoxy compound, an alicyclic epoxy compound, and an aliphatic epoxy compound.

Examples of the aromatic epoxy compound include glycidyl ethers of monovalent or polyvalent phenols having at least one aromatic ring (phenol, bisphenol A, phenol novolak, and compounds being alkylene oxide adducts of the preceding phenols).

Examples of the alicyclic epoxy compound include a compound obtained by epoxidizing a compound having at least one cyclohexene or cyclopentene ring with an oxidizing agent, e.g., 3,4-epoxycyclohexylmethyl-3,4-epoxycyclohexane carboxylate.

Examples of the aliphatic epoxy compound include a polyglycidyl ether of an aliphatic polyhydric alcohol or an alkylene oxide adduct thereof (e.g., 1,4-butanediol diglycidyl ether and 1,6-hexanediol diglycidyl ether), a polyglycidyl ester of an aliphatic polybasic acid (e.g., diglycidyl tetrahydrophthalate), and an epoxidized product of a long chain unsaturated compound (e.g., epoxidized soybean oil and epoxidized polybutadiene).

Among those, a polyfunctional epoxy compound that is liquid at normal temperature (20°C) is preferred, and the polyfunctional epoxy compound preferably has an epoxy equivalent of 80 g/eq. or more and 500 g/eq. or less. The fact that the polyfunctional epoxy compound is liquid at normal temperature is preferable in that the compatibility with the polyimide resin (A) is improved and a fine patterning property is obtained. On the other hand, it is preferable that the epoxy equivalent of the polyfunctional epoxy compound be 80 g/eq. or more and 500 g/eq. or less in that the heat resistance and chemical resistance of a cured film are improved.

As the oxetane compound, publicly-known compounds, etc. can be used, and examples thereof include 3-ethyl-3-hydroxymethyloxetane, 2-ethylhexyl (3-ethyl-3-oxetanylmethyl) ether, 2-hydroxyethyl (3-ethyl-3-oxetanylmethyl) ether, 2-hydroxypropyl (3-ethyl-3-oxetanylmethyl) ether, 3-ethyl-3-{[(3-ethyloxetan-3-yl)methoxy]methyl}oxetane, 1,4-bis[(3-ethyl-3-oxetanylmethoxy)methyl]benzene, 4,4'-bis[(3-ethyloxetan-3-yl)methoxy]biphenyl, oxetanyl silsesquioxetane, and phenol novolak oxetane. Here, epoxy compounds having an oxetanyl group correspond to oxetane compounds. Among them, oxetane compounds containing two or more oxetanyl groups in the molecule are preferable, and the number of the oxetanyl groups in one molecule is more preferably two or more and six or less. It is preferable that the oxetane compound contain two or more oxetanyl groups in that curability is improved, and it is preferable that the number of

oxetanyl groups be six or less in that cracks generated during pattern processing can be suppressed.

As the ethylenically unsaturated compound, publicly-known cationically polymerizable monomers and the like can be used, and an aliphatic monovinyl ether, an aromatic monovinyl ether, a polyfunctional vinyl ether, styrene, and a cationically polymerizable nitrogen-containing monomer are included.

Examples of the aliphatic monovinyl ether include methyl vinyl ether, ethyl vinyl ether, butyl vinyl ether, and cyclohexyl vinyl ether.

Examples of the aromatic monovinyl ether include 2-phenoxyethyl vinyl ether, phenyl vinyl ether, and p-methoxyphenyl vinyl ether.

Examples of the polyfunctional vinyl ether include butanediol-1,4-divinyl ether and triethylene glycol divinyl ether.

Examples of the styrenes include styrene, α-methylstyrene, p-methoxystyrene, and p-tert-butoxystyrene.

Examples of the cationically polymerizable nitrogen-containing monomer include N-vinylcarbazole and N-vinylpyrrolidone.

As the episulfide compound, publicly-known compounds can be used, and examples thereof include 2,2-bis [4-(2,3-epithiopropoxy)phenyl]propane and 2,2-bis[4-(2,3-epithiopropoxy)cyclohexyl]propane.

Examples of the bicyclo orthoesters include 1-phenyl-4-ethyl-2,6,7-trioxabicyclo[2.2.2]octane and 1-ethyl-4-hydroxymethyl-2,6,7-trioxabicyclo-[2.2.2]octane.

Examples of the spiro orthocarbonates include 1,5,7,11-tetraoxaspiro[5.5]undecane and 3,9-dibenzyl-1,5,7,11-tetraoxaspiro[5.5]undecane.

Examples of the spiro orthoesters include 1,4,6-trioxaspiro[4.4]nonane, 2-methyl-1,4,6-trioxaspiro[4.4]nonane, and 1,4,6-trioxaspiro[4.5]decane.

The cationically polymerizable compound (B) preferably contains an epoxy compound and/or an oxetane compound from the viewpoint of exhibiting sufficient cationic polymerizability and improving curability.

In particular, when the cationically polymerizable compound (B) contains the oxetane compound, cationic polymerizability is improved, and water absorption can be more effectively reduced.

The oxetane compound more preferably contains an oxetane compound (B1) represented by the following formula (8).

[Chemical Formula 15]

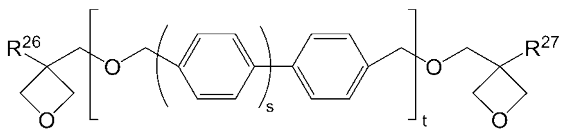

(8)

In the formula (8), s and t each independently represent an integer of 0 to 6, and $R^{26}$ and $R^{27}$ each independently represent a monovalent organic group having 1 to 5 carbon atoms.

The oxetane compound (B1) can more effectively relieve the residual stress of a cured film. Examples of the oxetane compound (B1) include OXT-121, OXT-221 (trade names, manufactured by Toagosei Co., Ltd.), and OXBP (trade name, manufactured by UBE Corporation).

In particular, when the cationically polymerizable compound (B) contains the epoxy compound, compatibility with the polyimide resin (A) can be improved, and residues can be improved.

The epoxy compound more preferably contains an epoxy compound (B2) represented by the following formula (9).

[Chemical Formula 16]

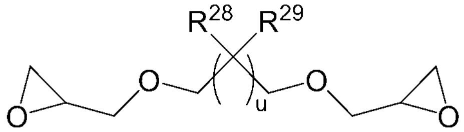

(9)

in the formula (9), u represents an integer of 1 to 5, and $R^{28}$ and $R^{29}$ each independently represent a hydrogen atom, a methyl group, or a group represented by formula (10):

[Chemical Formula 17]

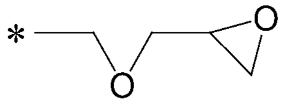
(10)

In the formula (10), the symbol * represents a bonding site.

By the epoxy compound (B2), developability can be improved, and resolution during pattern processing can be more effectively improved. Examples of the epoxy compound (B2) include EPOGOSEY BD(D), EPOGOSEY NPG(D) (trade names, manufactured by Yokkaichi Chemical **Co.,** Ltd.), and SHOFREE PETG (trade name, manufactured by Resonac Corporation).

Further, it is preferable that the cationically polymerizable compound (B) contain an epoxy compound and an oxetane compound, and the amount of the epoxy compound be 10 to 250 parts by mass with respect to 100 parts by mass of the oxetane compound. When the amount of the epoxy compound is 10 parts by mass or more, more preferably 20 parts by mass or more, the resolution during pattern processing is more effectively improved. When the amount of the epoxy compound is 250 parts by mass or less, more preferably 100 parts by mass, cationic polymerizability is improved, photosensitivity is improved, and the water absorption and the residual stress of a cured film can be more effectively reduced.

The negative photosensitive resin composition of the present invention contains a photocationic polymerization initiator as the cationic polymerization initiator (C). The cationic polymerization initiator (C) is an agent that generates an acid with light to cause cationic polymerization.

As the cationic polymerization initiator (C), publicly-known compounds can be used, and from the viewpoint of cationic curability and copper corrosiveness, the cationic polymerization initiator (C) preferably contains a sulfonium salt containing at least one selected from the group consisting of a borate ion, a phosphate ion, and a gallate ion as a counter anion. Here, the borate ion is a complex ion having boron as a central atom, the phosphate ion is a complex ion having phosphorus as a central atom, and the gallate ion is a complex ion having gallium as a central atom.

Examples of the cation that forms the sulfonium salt include, but are not limited to, triarylsulfoniums such as triphenylsulfonium, tri-p-tolylsulfonium, tris(4-methoxyphenyl)sulfonium, 1-naphthyldiphenylsulfonium, 2-naphthyldiphenylsulfonium, tris(4-fluorophenyl)sulfonium, tri-1-naphthylsulfonium, tri-2-naphthylsulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis[4-(diphenylsulfonio)phenyl]sulfide, bis[4-{bis[4-(2-hydroxyethoxy)phenyl]sulfonio}phenyl]sulfide, bis{4-[bis(4-fluorophenyl)sulfonio]phenyl}sulfide, bis{4-[bis(4-methylphenyl)sulfonio]phenyl}sulfide, bis{4-[bis(4-methoxyphenyl)sulfonio]phenyl}sulfide, 4-(4-benzoyl-2-chlorophenylthio)phenylbis(4-fluorophenyl)sulfonium, 4-(4-benzoyl-2-chlorophenylthio)phenyldiphenylsulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yl di-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-ylphenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thiaanthrenium, 5-phenylthiaanthrenium, 5-tolylthiaanthrenium, 5-(4-ethoxyphenyl)thiaanthrenium, and 5-(2,4,6-trimethylphenyl)thiaanthrenium; diarylsulfoniums such as diphenylphenacylsulfonium, diphenyl 4-nitrophenacylsulfonium, diphenylbenzylsulfonium, and diphenylmethylsulfonium; monoarylsulfoniums such as phenylmethylbenzylsulfonium, 4-hydroxyphenylmethylbenzylsulfonium, 4-methoxyphenylmethylbenzylsulfonium, 4-acetocarbonyloxyphenylmethylbenzylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-acetocarbonyloxyphenylmethylphenacylsulfonium, 2-naphthylmethylphenacylsulfonium, 2-naphthyloctadecylphenacylsulfonium, and 9-anthracenylmethylphenacylsulfonium; dimethylphenacylsulfonium, phenacyltetrahydrothiophenium, dimethylbenzylsulfonium, benzyltetrahydrothiophenium, and octadecylmethylphenacylsulfonium.

Examples of the borate ion include, but are not limited to, pentafluorophenylborate, trifluorophenylborate, tetrafluorophenylborate, trifluoromethylphenylborate, bis(trifluoromethyl)phenylborate, pentafluoroethylphenylborate, bis(pentafluoroethyl)phenylborate, fluoro-bis(trifluoromethyl)phenylborate, fluoro-pentafluoroethylphenylborate, and fluoro-bis(pentafluoroethyl)phenylborate.

Examples of the phosphate ion include, but are not limited to, hexafluorophosphate and tris(pentafluoroethyl) trifluorophosphate.

Examples of the gallate ion include, but are not limited to, tetrakis(pentafluorophenyl)gallate and tetrakis(3,5-bis(trifluoromethyl)phenyl)gallate.

The content of the cationic polymerization initiator (C) is preferably 0.3 parts by mass or more and 10 parts by

mass or less, more preferably 0.5 parts by mass or more and 8 parts by mass or less, and particularly preferably 0.7 parts by mass or more and 6 parts by mass or less, with respect to 100 parts by mass of the cationically polymerizable compound (B). When the content of the cationic polymerization initiator (C) is set within the above range, the cationically polymerizable compound (B) is sufficiently cationically polymerized, so that the patterning property is improved, and the storage stability of the negative photosensitive resin composition is improved.

It is also preferable that the negative photosensitive resin composition of the present invention contain a methylol-based crosslinking agent (D). When the methylol-based crosslinking agent (D) is contained, the resolution during pattern processing is more effectively improved. As the methylol-based crosslinking agent (D), compounds having an alkoxymethyl group and a methylol group are preferable.

In addition, the methylol-based crosslinking agent (D) preferably contains a compound (D1) represented by the following formula (11). When the compound (D1) is contained, developability is improved, and an exposure margin is more effectively expanded.

[Chemical Formula 18]

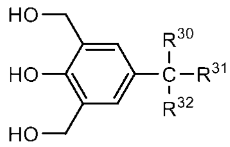

(11)

in the formula (11), $R^{30}$, $R^{31}$ and $R^{32}$ each independently represent a hydrogen atom, a methyl group, or a group represented by formula (12):

[Chemical Formula 19]

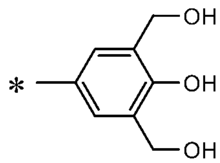

(12)

In the formula (12), the symbol * represents a bonding site.

Examples of the methylol-based crosslinking agent (D1) include 26DMPC, 26DMPEP, TM-BIP-A, and HM-HAP(trade names: manufactured by Asahi Yukizai Corporation).

The negative photosensitive resin composition of the present invention may contain a sensitizer. The sensitizer is a compound capable of absorbing light, donating the absorbed light energy to the cationic polymerization initiator (C), generating an acid, and causing cationic polymerization. In addition, because the sensitizer absorbs light with respect to the irradiation wavelength applied during pattern processing, the transmittance of a negative photosensitive resin composition film formed of the negative photosensitive resin composition can be reduced. Therefore, the transmittance of the negative photosensitive resin composition film can be arbitrarily controlled through the content of the sensitizer in the negative photosensitive resin composition.

The sensitizer is not particularly limited, but anthracene compounds are preferable, and for example, anthracene compounds having alkoxy groups at the 9- and 10-positions (9,10-dialkoxy-anthracene derivatives) are more preferable. Examples of the alkoxy groups include alkoxy groups having 1 to 4 carbon atoms such as a methoxy group, an ethoxy group, and a propoxy group. The 9,10-dialkoxy-anthracene derivative may further have a substituent. Examples of the substituent include a halogen atom such as a fluorine atom, a chlorine atom, a bromine atom, and an iodine atom, an alkyl group having 1 to 4 carbon atoms such as a methyl group, an ethyl group, and a propyl group, a sulfonic acid alkyl ester group, and a carboxylic acid alkyl ester group. Examples of the alkyl in the sulfonic acid alkyl ester group and the carboxylic acid alkyl ester include alkyl having 1 to 4 carbon atoms such as methyl, ethyl, and propyl. The substitution position of these substituents is preferably the 2-position.

The content of the sensitizer is not particularly limited, but is preferably 0.05% by mass or more, and more preferably 0.1% by mass or more where the mass of the entire negative photosensitive resin composition is 100% by mass. Thereby, the transmittance of a negative photosensitive resin composition film can be reduced, and even on a substrate having a rough surface such as ceramics, reflection of light from the substrate surface is suppressed, and processing of a fine pattern is facilitated. Meanwhile, the content of the sensitizer is preferably 10% by mass or less, and more preferably 5% by mass or less where the mass of the entire negative photosensitive resin composition is 100% by mass, from the

viewpoint of suppressing deterioration in mechanical characteristics and thermal characteristics of a cured film of a negative photosensitive resin composition film formed from the negative photosensitive resin composition.

The negative photosensitive resin composition of the present invention may contain a silane compound. When the silane compound is contained, the adhesion between a cured product and a substrate is improved. Here, a silane compound having a cationically polymerizable functional group corresponds to the cationically polymerizable compound (B). Examples of a cationically polymerizable group include an epoxy group, an oxetanyl group, and a vinyl ether group. Among them, examples of a silane compound containing an epoxy group include KBM-303 and KBM-403 (trade names, manufactured by Shin-Etsu Chemical Co., Ltd.).

The negative photosensitive resin composition of the present invention may further contain a publicly-known antioxidant and a publicly-known surfactant. In addition, inorganic particles such as silicon dioxide and titanium dioxide, a powder of polyimide, or the like may be contained for the purposes of controlling the thermal expansion coefficient, increasing the dielectric constant, decreasing the dielectric constant, and the like.

In the negative photosensitive resin composition of the present invention, the content of fluorine atoms in 100% by mass of the negative photosensitive resin composition excluding the solvent is preferably 0.0% by mass or more and 3.0% by mass or less. When the content of fluorine atoms is 3.0% by mass or less, a deposit which is a reaction product of a metal with a fluorine atom-containing organic component generated as a decomposition gas from the negative photosensitive resin composition is less prone to occur during dry etching. Examples of the metal include Al, Pt, Cu, Au, Ti, Ni, Cr, W, Pd, Co, and Mn. That is, by virtue of the use of the negative photosensitive resin composition of the present invention, it is possible to provide a highly reliable electronic component with an organic insulating film even when the electronic component has a metal electrode.

The content of fluorine atoms in 100% by mass of the negative photosensitive resin composition excluding the solvent can be analyzed by a method in accordance with BS EN 14582 (2016) with the total solid content as 100% by mass.

Specifically,

first, a resin film component is separated from the negative photosensitive resin composition;
the resin film component separated is precisely weighed as a sample;
using an automatic sample combustion device, the sample is combusted in a combustion tube of the analyzer, and the gas generated is absorbed into an aqueous solution containing 0.036% by mass of $H_2O_2$, and then a part of the absorption liquid is analyzed by ion chromatography.

When the negative photosensitive resin composition is prepared using a polymerization liquid of the polyimide resin (A) without purification, the content of fluorine atoms can also be calculated from the feed ratio at the time of the preparation.

The cured product of the present invention is a cured product produced by curing the negative photosensitive resin composition. That is, the cured product of the present invention is derived from the negative photosensitive resin composition of the present invention. The cured product may be a cured product in any form, e.g., a cured film, as long as the cured product is one produced by curing the photosensitive resin composition by light or heat.

Examples of the method of curing by light or heat include publicly-known methods such as a method of performing curing by exposure to light at 50 mJ or more and 3000 mJ or less with 365 nm i-line, 405 nm h-line, and 432 nm g-line of a high-pressure mercury lamp, and a method of performing curing by heat treatment at 150°C or more and 500°C or less for 5 minutes or more and 5 hours or less.

Next, a method for producing the cured product of the present invention will be described. A method for producing a cured product includes a step of applying the negative photosensitive resin composition onto a substrate and drying the negative photosensitive resin composition to form a photosensitive resin film on the substrate; a step of exposing the photosensitive resin film to light; a step of removing an unexposed portion of the photosensitive resin film with an alkali aqueous solution to develop the photosensitive resin film; and a step of heat-treating the developed photosensitive resin film to form a cured product.

The step of applying the negative photosensitive resin composition onto a substrate and drying the negative photosensitive resin composition to form a photosensitive resin film on the substrate may be, for example, but is not limited to, a step of applying the photosensitive resin composition onto a substrate with a spin coater, a spray coater, a screen coater, a blade coater, a die coater, a calender coater, a meniscus coater, a bar coater, a roll coater, a comma roll coater, a gravure coater, a slit die coater, or the like, and drying the photosensitive resin composition in a range of 50°C or more and 150°C or less for 1 minute or more and several hours or less to form a photosensitive resin film.

The step of exposing the photosensitive resin film to light may be, for example, but is not limited to, a step of exposing the photosensitive resin film to light at 50 mJ or more and 3000 mJ or less with a 365 nm i-line, a 405 nm h-line, and a 432 nm g-line of a high-pressure mercury lamp through a mask having a desired pattern. The photosensitive resin film exposed by the above step may be subjected to post-exposure baking. The post-exposure baking is preferably performed at 50°C or more from the viewpoint of curability and adhesion to the substrate, and is preferably performed at 150°C or less

from the viewpoint of resolution.

Examples of the step of removing an unexposed portion of the photosensitive resin film with an alkaline aqueous solution to develop the photosensitive resin film include, but are not limited to, a step of spraying an alkaline aqueous solution to the surface of the photosensitive resin film, a step of covering the surface of the film with a developer, a step of immersing the photosensitive resin film in an alkaline aqueous solution, and a step of immersing the photosensitive resin film in an alkaline aqueous solution followed by the application of ultrasonic waves. Development conditions such as the development time and the temperature of the developer in the developing step may be any conditions under which an exposed portion is removed and a pattern can be formed. A rinsing treatment with water is preferably performed after the development. The rinsing treatment may be performed by adding an alcohol such as ethanol or isopropyl alcohol, ethyl lactate, propylene glycol monomethyl ether acetate, or the like to water, as necessary.

The step of heat-treating the developed photosensitive resin film to form a cured product may be, for example, but is not limited to, a step of subjecting the photosensitive resin film to a heat treatment in a range of 150°C or more and 500°C or less for 5 minutes or more and 5 hours or less to advance a thermal crosslinking reaction and form a cured product. The heat treatment can be carried out by a method of raising the temperature stepwise to appropriately selected temperatures or a method of raising the temperature continuously over an appropriately selected temperature range. The former method may be, for example, but is not limited to, a method of performing the heat treatment at 130°C and 200°C each for 30 minutes. The latter method may be, for example, but is not limited to, a method of raising the temperature linearly from room temperature to 400°C over 2 hours.

The hollow structure of the present invention includes a support material containing the cured product described above.

The hollow structure is a structure composed of a recess or a protrusion provided in an electronic component and a roof portion, and the roof portion is formed by thermocompression-bonding a film of the negative photosensitive resin composition to the recess or the protrusion. For the recess or the protrusion, the photosensitive resin composition can be used as a support material. The thickness of the support material of the hollow structure is preferably 5 μm or more and 30 μm or less. The thickness of the roof portion is preferably 10 μm or more and 30 μm or less. When the thickness of the support material is 5 μm or more, a hollow structure can be formed, whereas when the thickness is 30 μm or less, a hollow structure that will not suffer from the collapse of the roof portion or the like can be obtained. In addition, when the thickness of the roof portion is 10 μm or more, the film strength of the roof portion is improved when the hollow structure is formed. The fact that the thickness is 30 μm or less is preferable in that the hollow structure can be thinned to contribute to miniaturization of an electronic component. The hollow structure is preferably sealed with a molding resin to enhance the robustness as an electronic component. That is, the hollow structure preferably has a structure in which the outer peripheral portion of the hollow structure is sealed with a molding resin. The method to be used for sealing the outer peripheral portion of the hollow structure with a molding resin may be, for example, but is not limited to, a transfer molding method or a compression molding method. In such molding methods as mentioned above, a sealed portion is formed by pouring a sealing resin, which is melted at a temperature of about 180°C, to the periphery of an electronic component with a pressure of about 6 MPa. That is, because a pressure of about 6 MPa is applied to the roof portion of the hollow structure at a high temperature during the sealing process, if the film strength of the cured product to be used as the roof portion of the hollow structure is low, the roof portion of the hollow structure may sag and the structure may collapse. In this respect, it is preferable that the hollow structure has sufficient film strength in that the yield of the electronic component in the step of sealing with a molding resin is improved.

The electronic component of the present invention includes the cured product described above. Electronic components refer to any devices that can function utilizing the characteristics of passive components (including a sensor, an antenna, an actuator, and the like using the function thereof), such as resistors, capacitors, and inductors, and semiconductor elements. An electrooptical device or a semiconductor circuit board in which a semiconductor element is connected to a substrate, a device in which multiple semiconductor elements are laminated, and an electronic device including these are all encompassed in the electronic component. The cured product is suitably used for applications such as a passivation film of a semiconductor, a surface protective film of a semiconductor element, an interlayer insulating film between a semiconductor element and wiring, an interlayer insulating film between a plurality of semiconductor elements, an interlayer insulating film between wiring layers of a multilayer wiring for high-density mounting, and an insulating layer of an organic electroluminescent element, but is not limited thereto, and can be used for various applications.

One example of the electronic component of the present invention is a semiconductor device having a multilayer wiring structure. One example of a method for manufacturing a semiconductor device having a multilayer wiring structure will be described. A barrier metal such as Ti is formed on a support substrate such as a glass substrate or a silicon wafer by a sputtering method, and a Cu seed (a seed layer) is further formed thereon by a sputtering method. Then, an electrode pad made of Cu is formed by a plating method. Subsequently, the resin composition of the present invention is applied onto the entire surface of the support substrate with the electrode pad formed thereon, and dried to form a resin film. The resulting resin film is irradiated with actinic rays at an exposure dose of 100 to 2000 $mJ/cm^2$ using an i-line stepper, a broadband aligner, or the like. Next, the exposed resin film is developed by dissolving and removing the exposed portion by

discharging a developer onto the exposed resin film, whereby a line-and-space pattern, a square pattern, or a hole pattern is formed. Then, heat treatment is performed to form a relief pattern layer of the cured film. The relief pattern layer serves as an insulating film. Subsequently, a seed layer is formed again by a sputtering method, and a metal wiring (rewiring layer) made of Cu is formed by a plating method. Thereafter, a process of from the step of the seed layer to the step of forming a metal wiring is repeatedly performed to form a multilayer wiring structure. Subsequently, the resin composition of the present invention is applied again, a pattern is formed using an actinic ray irradiation step, and then an insulating film is formed by curing through a heat treatment, and then a Cu post is formed on the metal wiring in an opening of the insulating film by a plating method. Here, the pitch of Cu posts and the pitch of conducting portions of the semiconductor chip are adjusted to be equal. That is, although the pitch of the conducting portions of the semiconductor chip is finer than the pitch of the electrode pad, each rewiring layer constituting the multilayer wiring structure makes the wiring multilayered while gradually making the pitch finer from the electrode pad to the Cu posts. The thickness of adjacent insulating films in the multilayer wiring structure also becomes the same or thinner as approaching the semiconductor chip. Next, a semiconductor chip is connected to the Cu post via a solder bump. As a result, the electrode pad and the semiconductor chip are electrically connected via the metal wiring and the solder bump. Thereafter, the semiconductor chip is sealed with a sealing resin to form a semiconductor package, and then the support substrate and the rewiring layer are peeled off to separate the semiconductor package. In this way, a semiconductor device having a multilayer wiring structure can be obtained.

As one example of an aspect of the electronic component of the present invention, the cured product described above is disposed as an insulating film between wirings. By disposing the cured product of the present invention as an insulating film in the form of a cured film between wirings, a multilayer wiring structure can be formed in which two or more layers of rewirings are separated by an insulating film made of the cured product of the resin composition of the present invention. Since the cured product is characterized by the low residual stress thereof, warpage of the package having the multilayer wiring structure can be reduced.

In the electronic component of the present invention, the cured product preferably has a residual stress under a dry nitrogen atmosphere of 15 to 35 MPa. When the residual stress is within the above range, a change in residual stress occurring in a heat cycle test of the electronic component is small, and the reliability of the electronic component can be improved.

One example of the electronic component of the present invention is an acoustic wave filter. That is, the acoustic wave filter of the present invention includes the cured product. Since the cured product is characterized by low residual stress, it can be suitably used for applications of a support material and a roofing material of an acoustic wave filter. In the acoustic wave filter of the present invention, the cured product particularly preferably has a residual stress under a dry nitrogen atmosphere of 15 to 35 MPa. When the residual stress is within the above range, the change in residual stress occurring in a heat cycle test of the acoustic wave filter is small, and the reliability of the acoustic wave filter can be improved.

An example of a method for manufacturing the acoustic wave filter of the present invention will be described. On a piezoelectric substrate, an inter digital transducer (IDT) electrode including a pair of comb-shaped electrodes each having a plurality of electrode fingers inserted between each other, and a bonding pad for electrical conduction are formed. Examples of the piezoelectric substrate include lithium niobate, potassium niobate, lithium tantalate, quartz, langasite, ZnO, PZT, and lithium tetraborate. Examples of the material of the electrode and the bonding pad include metals such as Al, Pt, Cu, Au, Ti, Ni, Cr, W, Pd, Co, and Mn. Further, a relief pattern layer of a cured film of a photosensitive resin composition is formed as a support material on the piezoelectric substrate in order to secure a hollow portion. Then, a hollow structure is formed by forming a roofing material on the support material. Here, the cured product of the present invention can be used as the support material. The cured product of the present invention can also be used for a roofing material of a hollow structure. The thickness of the support material is, for example, 20 μm. Then, a protective member is provided in such a manner that the protective member covers the piezoelectric substrate, the support material, and the roofing material. The protective member is an insulating material, and examples thereof include an epoxy resin, a benzocyclobutene resin, a silicon-based resin, and a spin on grass (SOG). Via conductors may be provided inside the support material and the covering material such that the via conductors penetrate in the thickness direction. Solder bumps are connected and formed on the via conductors.

## EXAMPLES

The present invention will be illustrated below with reference to Examples, but it should be understood that the present invention is not limited only to the Examples.

[Evaluation methods]

(1) Storage stability

After a lapse of 12 to 24 hours from the preparation of a negative photosensitive resin composition, the viscosity at 25°C was measured using an E-type viscometer (TVE -25 manufactured by Toki Sangyo Co., Ltd.), and the value was taken as $V_1$. Thereafter, the negative photosensitive resin composition was sealed and stored at room temperature (23°C) for 2 weeks, and then the viscosity thereof was measured, and the value was taken as $V_2$. Where the viscosity increase rate (%) is defined by $[(V_2 - V_1)/V_1] \times 100$, the storage stability was evaluated under the following criteria, and D and above were evaluated as acceptable

A: the viscosity increase rate is less than 4%,
B: the viscosity increase rate is 4% or more and less than 9%,
C: the viscosity increase rate is 9% or more and less than 13%,
D: the viscosity increase rate is 13% or more and less than 17%,
E: the viscosity increase rate is 17% or more.

(2) Photosensitivity (cationic curability)

A negative photosensitive resin composition was applied to a silicon wafer with a spin coater (1H-360S manufactured by Mikasa Co., Ltd.), and then prebaked at 120°C for 3 minutes using a hot plate (SCW-636 manufactured by Dainippon Screen Mfg. Co., Ltd.). Thus, a coat film with a thickness of 15 μm was prepared. Using a parallel light mask aligner (PLA-501F manufactured by Canon Inc.) and using an ultra-high pressure mercury lamp as light source, the resulting coat film was exposed to light at an exposure dose of 300mJ/cm$^2$, 500 mJ/cm$^2$, 700 mJ/cm$^2$, 1000 mJ/cm$^2$, 1500 mJ/cm$^2$, 2000 mJ/cm$^2$ or 2500 mJ/cm$^2$ through a mask having a line & space pattern with a line width of 60 μm and a space of 30 μm. The exposure dose was calculated from i-line (365 nm) illuminance measurements.

Subsequently, the resulting coat film was subjected to post-exposure baking at 100°C for 3 minutes, and developed for a time period twice as long as the time period required for complete dissolution of the unexposed portion in a 2.38% by mass aqueous solution of tetramethylammonium hydroxide (TMAH) using an automatic developing machine (AD-1200 manufactured by Takizawa Sangyo Co., Ltd.), followed by rinsing with pure water for 30 seconds.

Thereafter, the pattern-processed portion was observed using an electron microscope, and a case where the minimum exposure dose at which a pattern was formed successfully without eluting a pattern having a line width of 60 μm and a space of 30 μm was 2500 mJ/cm$^2$ or less was evaluated as acceptable.

(3) Resolution (Patterning property)

A coat film having a thickness of 15 μm was prepared in the same manner as in the above section (2). Using a parallel light mask aligner (PLA-501F manufactured by Canon Inc.), the resulting coat film was exposed to light emitted from an ultra-high pressure mercury lamp used as a light source to the minimum exposure dose at which a pattern with a line width of 60 μm and a space of 30 μm was formed successfully without elution in the above section (2) through masks capable of forming a pattern with a line width of 60 μm and a space of 30 μm, a pattern with a line width of 40 μm and a space of 20 μm, a pattern with a line width of 20 μm and a space of 10 μm, and a pattern with a line width of 15 μm and a space of 5 μm.

Subsequently, the resulting coat film was subjected to post-exposure baking at 100°C for 3 minutes, and developed for a time period twice as long as the time period required for complete dissolution of the unexposed portion in a 2.38% by mass aqueous TMAH solution using an automatic developing machine, followed by rinsing with pure water for 30 seconds.

Thereafter, the pattern-processed portion was observed using an electron microscope, and a case where the minimum pattern size having no abnormality such as incomplete removal or elution was 30 μm or less was evaluated as acceptable.

(4) Exposure margin

A coat film having a thickness of 15 μm was prepared in the same manner as in the above section (2). Using a parallel light mask aligner (PLA-501F manufactured by Canon Inc.), the resulting coat film was exposed to light emitted from an ultra-high pressure mercury lamp used as a light source, at the minimum exposure dose at which a pattern with a line width of 60 μm and a space of 30 μm was formed successfully without elution in the above section (2) through masks having a circular pattern with a diameter of 40 μm, and at an exposure dose 1.5 times the minimum exposure dose.

Subsequently, the resulting coat film was subjected to post-exposure baking at 100°C for 3 minutes, and developed for a time period twice as long as the time period required for complete dissolution of the unexposed portion in a

2.38% by mass aqueous TMAH solution using an automatic developing machine, followed by rinsing with pure water for 30 seconds.

Thereafter, the pattern-processed portion was observed using an optical microscope, and the via diameter ($D_1$) at the minimum exposure dose and the via diameter ($D_2$) at an exposure dose 1.5 times the minimum exposure dose were measured up to the first decimal place. Then, the amount of change, $D_1 - D_2$, was calculated. The smaller the amount of change is, the better the dimensional stability is.

Under the following criteria, D and above were evaluated as acceptable

A: the amount of change is less than 2.0 μm,
B: the amount of change is 2.0 μm or more and less than 4.0 μm,
C: the amount of change is 4.0 μm or more and less than 6.0 μm,
D: the amount of change is 6.0 μm or more and less than 8.0 μm,
E: the amount of change is 8.0 μm or more.

(5) Residual stress

A negative photosensitive resin composition was applied to and prebaked on a silicon wafer with a spin coater and a hot plate such that the film prebaked at 120°C for 3 minutes had a thickness of 10 μm, then the entire surface was exposed to 2000 mJ/cm$^2$ using a parallel light mask aligner. Then, the temperature was raised to 200°C at a heating rate of 3.5°C/min at an oxygen concentration of 20 ppm or less using an inert oven (CLH-21CD-S manufactured by Koyo Thermo Systems Co., Ltd.), and a heat treatment was performed at 200°C for 1 hour.

Thereafter, the residual stress of the cured film was evaluated using a stress measurement system (FLX 3300-T manufactured by Toho Technology Corporation). Where the substrate was designed to have an elastic modulus of 1.805 and a thickness of 625 μm, the change in the radius of curvature of the silicon wafer between before and after the formation of the cured film was measured at 23°C using a laser with a wavelength of 670 nm, and the residual stress in the cured film was calculated using the Stoney formula.

The cured film prepared by the above method was stored in an environment at 23°C and 45%RH for 24 hours. Then, nitrogen gas was flowed at 1.0 MPa for 30 minutes and residual stress in a dry state was measured. An integer value obtained by rounding off the first decimal place of the measured value was taken as a measurement result. Under the following criteria, D and above were evaluated as acceptable

A: the residual stress in this dry state is less than 26 MPa,
B: the residual stress is 26 MPa or more and less than 31 MPa,
C: the residual stress is 31 MPa or more and less than 36 MPa,
D: the residual stress is 36 MPa or more and less than 41 MPa,
E: the residual stress is 41 MPa or more.

(6) Water absorption

A cured film was prepared on a silicon wafer in the same manner as in the above section (5), and the residual stress was measured using a stress measurement system (FLX 3300-T manufactured by Toho Technology Corporation). The residual stress ($S_1$) immediately after storing the cured film in an environment of 23°C and 45%RH for 24 hours and the residual stress ($S_2$) in a dry state after flowing nitrogen gas at 1.0 MPa for 30 minutes were measured each to the first decimal place. Then, the amount of increase, $S_2 - S_1$, was rounded at the first decimal place, and the resulting integer value was used as a measurement result. The smaller the amount of increase is, the better the water absorption is.

Under the following criteria, D and above were evaluated as acceptable

A: the amount of increase is less than 11 MPa,
B: the amount of increase is 11 MPa or more and less than 16 MPa,
C: the amount of increase is 16 MPa or more and less than 21 MPa,
D: the amount of increase is 21 MPa or more and less than 26 MPa,
E: the amount of increase is 26 MPa or more.

(7) Residue

A coat film having a thickness of 15 μm was prepared in the same manner as in the above section (2). Using a parallel light mask aligner (PLA-501F manufactured by Canon Inc.) and using an ultra-high pressure mercury lamp as light source, the resulting coat film was exposed to light. In the exposure, the resulting coat film was exposed to light at the

minimum exposure dose at which a pattern with a line width of 60 μm and a space of 30 μm was formed successfully without elution in the above section (2) through a mask having a square pattern 40 μm on each side.

Subsequently, the resulting coat film was subjected to post-exposure baking at 100°C for 3 minutes, and developed for a time period twice as long as the time period required for complete dissolution of the unexposed portion in a 2.38% by mass aqueous TMAH solution using an automatic developing machine, followed by rinsing with pure water for 30 seconds.

Thereafter, the pattern-processed portion was observed using an optical microscope and subjected to focus adjustment to measure the opening dimension ($L_1$) of the outermost surface and the opening dimension ($L_2$) of the lowest surface each to the second decimal place. Then, the difference in opening size, $L_1$ - $L_2$, was rounded off to one decimal place, and the result up to the first decimal place was taken as a measurement result. When a residue is generated, the trailing increases, and thus the opening dimension on the lowest surface is reduced. That is, the smaller the difference in opening size is, the smaller the amount of the residue is and the better it is.

Under the following criteria, D and above were evaluated as acceptable

A: the difference in opening size is less than 1.5 μm,
B: the difference in opening size is 1.5 μm or more and less than 2.5 μm,
C: the difference in opening size is 2.5 μm or more and less than 3.5 μm,
D: the difference in opening size is 3.5 μm or more and less than 4.5 μm,
E: the difference in opening size is 4.5 μm or more.

(8) Fluorine atom content in total solid content in negative photosensitive resin composition

A combustion test in accordance with BS EN 14582 (2016) was carried out. The negative photosensitive resin compositions prepared in the examples and comparative examples described later were each precisely weighed as samples. Using the automatic sample combustion device described below, a sample was combusted in the combustion tube of the analyzer, the generated gas was absorbed into an absorbent solution, and then a part of the resulting absorbent solution was analyzed by ion chromatography. When the sample was a solution of a resin, the total fluorine atom content (% by mass) in the obtained sample was divided by the solid concentration (% by mass) described above, and multiplied by 100 to determine the fluorine atom content (% by mass) in the resin.

<Combustion/absorption conditions>

System: AQF-2100H and GA-210 (manufactured by Mitsubishi Chemical Corporation)
Electric furnace temperature: 900°C at the inlet and 1000°C at the outlet
Gas: Ar/$O_2$ 200 mL/min
: $O_2$/ 400 mL/min
Absorbent: 0.036% by mass aqueous solution of $H_2O_2$, internal standard P 4 μg/mL
Volume of absorbent: 20 mL
<Ion chromatography/anion analysis conditions>
System: ICS-1600 (manufactured by DINONEX)
Mobile phase: 2.7 mmol/L $Na_2CO_3$/0.3 mmol/L $NaHCO_3$
Flow rate: 1.5 mL/min
Detector: electrical conductivity detector
Injection amount: 20 μL.

(9) Organic deposit on aluminum electrode

A coat film having a thickness of 15 μm was prepared in the same manner as in the above section (2) on a silicon substrate having 20 aluminum electrodes and having a size of 5 cm × 5 cm. A mask with a pattern having a via size of 100 μmφ was set such that the opening of the via overlapped each of the aluminum electrode portion and the silicon portion. Using a parallel light mask aligner (PLA-501F manufactured by Canon Inc.), exposure was performed using an ultra-high pressure mercury lamp as a light source. As the exposure dose, the minimum exposure dose at which a pattern with a line width of 60 μm and a space of 30 μm was formed successfully without elution in the above section (2) was adopted.

Subsequently, the resulting coat film was subjected to post-exposure baking at 100°C for 3 minutes, and developed for a time period twice as long as the time period required for complete dissolution of the unexposed portion in a 2.38% by mass aqueous TMAH solution using an automatic developing machine, followed by rinsing with pure water for 30

seconds. Then, the temperature was raised to 200°C at a heating rate of 3.5°C/min at an oxygen concentration of 20 ppm or less using an inert oven (CLH-21CD-S manufactured by Koyo Thermo Systems Co., Ltd.), and a heat treatment was performed at 200°C for 1 hour. Thereby, a cured film of a negative photosensitive resin composition pattern-formed on the silicon substrate with the aluminum electrodes was obtained.

The substrate with the pattern-processed cured film was subjected to an etching treatment in an etching apparatus for 7 minutes at an output of 100 W and a process pressure of 10 Pa using a mixed gas composed of 20% by volume of oxygen and 80% by volume of tetrafluoromethane at a flow rate of 25 sccm ($15 \times 10^{-4}$ $m^3/h$).

The pattern after the etching treatment was observed with an optical microscope, and the presence or absence of organic deposits on the 20 aluminum electrodes was examined.

Under the following criteria, A and B were evaluated as acceptable

A: the number of the electrodes with an organic deposit found thereon among the 20 aluminum electrodes is less than 3,
B: the number of the electrodes with an organic deposit found thereon is 3 or more and less than 6,
**C:** the number of the electrodes with an organic deposit found thereon is 6 or more.

(10) Heat resistance

A negative photosensitive resin composition was applied to and prebaked on a silicon wafer with a spin coater and a hot plate such that the film prebaked at 100°C for 3 minutes had a thickness of 10 μm, then the entire surface was exposed to 2000 $mJ/cm^2$ using a parallel light mask aligner. Then, the temperature was raised to 200°C at a heating rate of 3.5°C/min at an oxygen concentration of 20 ppm or less using an inert oven (CLH-21CD-S manufactured by Koyo Thermo Systems Co., Ltd.), and a heat treatment was performed at 200°C for 1 hour.

Subsequently, the silicon wafer was immersed in a 45% by mass aqueous hydrofluoric acid solution for 5 minutes to peel off the cured film of the negative photosensitive resin composition from the wafer. Then, a sample was cut out from the cured film to a size of 3.0 cm × 1.5 cm with a single-edge blade, and measurement was performed under a nitrogen flow, from 25°C to 400°C, at a heating rate of 10°C/min using a thermomechanical analyzer (TMA/SS6100 manufactured by Seiko Instruments Inc.). The heat resistance was evaluated under the following criteria, A: the glass transition temperature is 230°C or more; B: the glass transition temperature is 200°C or more and less than 230°C; C: the glass transition temperature is less than 200°C.

In the following, the abbreviations of the names of the compounds used in the synthesis examples and the examples will be described.

GBL: gamma butyrolactone
TDA-100: 4-(2,5-dioxotetrahydrofuran-3-yl)-1,2,3,4-tetrahydronaphthalene-1,2-dicarboxylic dianhydride
6FAP: bis(3-amino-4-hydroxyphenyl)hexafluoropropane
P1075: dimer diamine having a structure of formula (4) (Priamine (registered trademark) 1075 manufactured by Croda Japan KK) (average amine value: 205)
SiDA: 1,3-bis(3-aminopropyl)tetramethyldisiloxane
RT-1000: diamine containing structure of formula (1) (trade name, manufactured by HUNTSMAN Corporation)
HMDA: hexamethylenediamine
BAHF: 9,9-bis(3-amino-4-hydroxyphenyl)fluorene
BAP: 2,2-bis(3-amino-4-hydroxyphenyl)propane
ABPS: bis(3-amino-4-hydroxyphenyl)sulfone
MAP: m-aminophenol
CPI-310FG: sulfonium salt containing gallate ion (trade name, manufactured by San-Apro Ltd.)
WPI-116: iodonium salt (trade name, manufactured by FUJIFILM Wako Pure Chemical Corporation)
OXE-02: oxime ester-based radical polymerization initiator (trade name, manufactured by BASF Japan Ltd.)
YL980: bisphenol A type epoxy resin (trade name, manufactured by Mitsubishi Chemical Corporation)
PETG: epoxy compound containing structure of formula (9) (trade name, manufactured by Resonac Corporation)
NPG (D): epoxy compound containing structure of formula (9) (trade name, manufactured by Yokkaichi Chemical Co., Ltd.)
OXT-191: oxetanyl silicate (trade name, manufactured by Toagosei Co., Ltd.)
OXT-121: oxetane compound containing structure of formula (8) (trade name, manufactured by Toagosei Co., Ltd.)
OXBP: oxetane compound containing structure of formula (8) (trade name, manufactured by Ube Industries, Ltd.)
CHDVE: 1,4-cyclohexanedimethanol divinyl ether
HMOM-HAP: methoxymethyl form (trade name, manufactured by Honshu Chemical Industry Co., Ltd.)
HM-HAP: methylol compound containing structure of formula (11) (trade name, manufactured by Asahi Yukizai

Corporation)
TM-BIP-A: methylol compound containing structure of formula (11) (trade name, manufactured by Asahi Yukizai Corporation)
M-315: triacrylate of modified isocyanuric acid (trade name, manufactured by Toagosei Co., Ltd.).

The compounds used in Examples and Comparative Examples were synthesized by the following methods.

[Synthesis Example 1] Synthesis of polyimide resin (P1)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP and 32.96 g (0.090 mol) of 6FAP were added, and the mixture was stirred at 60°C for 1 hour, then heated to 200°C, and stirred for 4 hours. The reaction solution was allowed to cool, affording a GBL solution of polyimide resin (P1). The polyimide resin (P1) has none of an alkyleneoxy skeleton, a siloxane skeleton, and an aliphatic hydrocarbon skeleton containing a linear structure. The raw material composition of the polyimide resin (P1) is shown in Table 1.

[Synthesis Example 2] Synthesis of polyimide resin (P2)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 29.30 g (0.080 mol) of 6FAP, and 5.39 g (0.010 mol) of P1075 were added, and the mixture was stirred at 60°C for 1 hour, then heated to 200°C, and stirred for 4 hours. The reaction solution was allowed to cool, affording a GBL solution of polyimide resin (P2). The polyimide resin (P2) has a dimer acid derivative skeleton which is an alicyclic skeleton containing an alkylene group as an aliphatic hydrocarbon skeleton containing a linear structure. The raw material composition of the polyimide resin (P2) is shown in Table 1.

[Synthesis Example 3] Synthesis of polyimide resin (P3)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 29.30 g (0.080 mol) of 6FAP, and 2.49 g (0.010 mol) of SiDA were added, and the mixture was stirred at 60°C for 1 hour, then heated to 200°C, and stirred for 4 hours. The reaction solution was allowed to cool, affording a GBL solution of polyimide resin (P3). The polyimide resin (P3) has a siloxane skeleton. The raw material composition of the polyimide resin (P3) is shown in Table 1.

[Synthesis Example 4] Synthesis of polyimide resin (P4)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 29.30 g (0.080 mol) of 6FAP, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P4). The polyimide resin (P4) has an alkyleneoxy skeleton represented by the formula (1). The alkyleneoxy equivalent of the polyimide resin (P4) is $6.7 \times 10^3$ g/mol. The raw material composition of the polyimide resin (P4) is shown in Table 1.

[Synthesis Example 5] Synthesis of polyimide resin (P5)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 29.30 g (0.080 mol) of 6FAP, and 1.16 g (0.010 mol) of HMDA were added, and the mixture was stirred at 60°C for 1 hour, then heated to 200°C, and stirred for 4 hours. The reaction solution was allowed to cool, affording a GBL solution of polyimide resin (P5). The polyimide resin (P5) has an alkylene group as an aliphatic hydrocarbon skeleton having a linear structure. The raw material composition of the polyimide resin (P5) is shown in Table 1.

[Synthesis Example 6] Synthesis of polyimide resin (P6)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 21.98 g (0.060 mol) of 6FAP, and 16.18 g (0.030 mol) of P1075 were added, and the mixture was stirred at 60°C for 1 hour, then heated to 200°C, and stirred for 4 hours. The reaction solution was allowed to cool, affording a GBL solution of polyimide resin (P6). The polyimide resin

(P6) has a dimer acid derivative skeleton as an aliphatic hydrocarbon skeleton containing a linear structure. The raw material composition of the polyimide resin (P6) is shown in Table 1.

[Synthesis Example 7] Synthesis of polyimide resin (P7)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 31.86 g (0.0830 mol) of 6FAP, and 1.62 g (0.003 mol) of P1075 were added, and the mixture was stirred at 60°C for 1 hour, then heated to 200°C, and stirred for 4 hours. The reaction solution was allowed to cool, affording a GBL solution of polyimide resin (P7). The polyimide resin (P7) has a dimer acid derivative skeleton as an aliphatic hydrocarbon skeleton containing a linear structure. The raw material composition of the polyimide resin (P7) is shown in Table 1.

[Synthesis Example 8] Synthesis of polyimide resin (P8)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 27.47 g (0.075 mol) of 6FAP, and 8.09 g (0.015 mol) of P1075 were added, and the mixture was stirred at 60°C for 1 hour, then heated to 200°C, and stirred for 4 hours. The reaction solution was allowed to cool, affording a GBL solution of polyimide resin (P8). The polyimide resin (P8) has a dimer acid derivative skeleton as an aliphatic hydrocarbon skeleton containing a linear structure. The raw material composition of the polyimide resin (P8) is shown in Table 1.

[Synthesis Example 9] Synthesis of polyimide resin (P9)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 32.60 g (0.089 mol) of 6FAP, and 1.00 g (0.001 mol) of RT-1000 were added, and the mixture was stirred at 60°C for 1 hour, then heated to 200°C, and stirred for 4 hours. The reaction solution was allowed to cool, affording a GBL solution of polyimide resin (P9). The polyimide resin (P9) has an alkyleneoxy skeleton represented by the formula (1). The alkyleneoxy equivalent of the polyimide resin (P9) is $61.3 \times 10^3$ g/mol. The raw material composition of the polyimide resin (P9) is shown in Table 1.

[Synthesis Example 10] Synthesis of polyimide resin (P10)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 31.86 g (0.087 mol) of 6FAP, and 3.00 g (0.003 mol) of RT-1000 were added, and the mixture was stirred at 60°C for 1 hour, then heated to 200°C, and stirred for 4 hours. The reaction solution was allowed to cool, affording a GBL solution of polyimide resin (P10). The polyimide resin (P10) has an alkyleneoxy skeleton represented by the formula (1). The alkyleneoxy equivalent of the polyimide resin (P10) is $20.9 \times 10^3$ g/mol. The raw material composition of the polyimide resin (P10) is shown in Table 1.

[Synthesis Example 11] Synthesis of polyimide resin (P11)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 25.64 g (0.070 mol) of 6FAP, and 20.00 g (0.020 mol) of RT-1000 were added, and the mixture was stirred at 60°C for 1 hour, then heated to 200°C, and stirred for 4 hours. The reaction solution was allowed to cool, affording a GBL solution of polyimide resin (P11). The polyimide resin (P11) has an alkyleneoxy skeleton represented by the formula (1). The alkyleneoxy equivalent of the polyimide resin (P11) is $3.7 \times 10^3$ g/mol. The raw material composition of the polyimide resin (P11) is shown in Table 1.

[Synthesis Example 12] Synthesis of polyimide resin (P12)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 5.49 g (0.015 mol) of 6FAP, 16.79 g (0.065 mol) of BAP, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P12). The polyimide resin (P12) has an alkyleneoxy skeleton represented by the formula (1). The alkyleneoxy equivalent of the polyimide resin (P12) is $6.0 \times 10^3$ g/mol. The raw material composition of the polyimide resin (P12) is shown in Table 1.

[Synthesis Example 13] Synthesis of polyimide resin (P13)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 14.65 g (0.040 mol) of 6FAP, 10.33 g (0.040 mol) of BAP, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P13). The polyimide resin (P13) has an alkyleneoxy skeleton represented by the formula (1). The alkyleneoxy equivalent of the polyimide resin (P13) is $6.3 \times 10^3$ g/mol. The raw material composition of the polyimide resin (P13) is shown in Table 1.

[Synthesis Example 14] Synthesis of polyimide resin (P14)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 5.49 g (0.015 mol) of 6FAP, 24.73 g (0.065 mol) of BAHF, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P14). The polyimide resin (P14) has an alkyleneoxy skeleton represented by the formula (1). The alkyleneoxy equivalent of the polyimide resin (P14) is $6.8 \times 10^3$ g/mol. The raw material composition of the polyimide resin (P14) is shown in Table 1.

[Synthesis Example 15] Synthesis of polyimide resin (P15)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 5.49 g (0.015 mol) of 6FAP, 18.22 g (0.065 mol) of ABPS, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P15). The polyimide resin (P15) has an alkyleneoxy skeleton represented by the formula (1). The alkyleneoxy equivalent of the polyimide resin (P15) is $6.1 \times 10^3$ g/mol. The raw material composition of the polyimide resin (P15) is shown in Table 1.

[Synthesis Example 16] Synthesis of polyimide resin (P16)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 10.33 g (0.040 mol) of BAP, 11.21 g (0.040 mol) of ABPS, and 10.00 g (0.010 mol) of RT-1000 were added, and the mixture was stirred at 60°C for 1 hour, then heated to 200°C and stirred for 4 hours. The reaction solution was allowed to cool, affording a GBL solution of polyimide resin (P16). The polyimide resin (P16) has an alkyleneoxy skeleton represented by the formula (1). The alkyleneoxy equivalent of the polyimide resin (P16) is $5.9 \times 10^3$ g/mol. The raw material composition of the polyimide resin (P16) is shown in Table 1.

[Synthesis Example 17] Synthesis of polyimide resin (P17)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 15.22 g (0.040 mol) of BAHF, 11.21 g (0.040 mol) of ABPS, and 10.00 g (0.010 mol) of RT-1000 were added, and the mixture was stirred at 60°C for 1 hour, and then heated to 200°C and stirred for 4 hours. The reaction solution was allowed to cool, affording a GBL solution of polyimide resin (P17). The polyimide resin (P17) has an alkyleneoxy skeleton represented by the formula (1). The alkyleneoxy equivalent of the polyimide resin (P17) is $6.4 \times 10^3$ g/mol. The raw material composition of the polyimide resin (P17) is shown in Table 1.

[Synthesis Example 18] Synthesis of polyimide resin (P18)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 10.33 g (0.040 mol) of BAP, 15.22 g (0.040 mol) of BAHF, and 10.00 g (0.010 mol) of RT-1000 were added, and the mixture was stirred at 60°C for 1 hour, and then heated to 200°C and stirred for 4 hours. The reaction solution was allowed to cool, affording a GBL solution of polyimide resin (P18). The polyimide resin (P18) has an alkyleneoxy skeleton represented by the formula (1). The alkyleneoxy equivalent of the polyimide resin (P18) is $6.3 \times 10^3$ g/mol. The raw material composition of the polyimide resin

(P18) is shown in Table 1.

[Synthesis Example 19] Synthesis of polyimide resin (P19)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 5.49 g (0.015 mol) of 6FAP, 16.79 g (0.065 mol) of BAP, and 5.39 g (0.010 mol) of P1075 were added, and the mixture was stirred at 60°C for 1 hour, then heated to 200°C, and stirred for 4 hours. The reaction solution was allowed to cool, affording a GBL solution of polyimide resin (P19). The polyimide resin (P19) has a dimer acid derivative skeleton as an aliphatic hydrocarbon skeleton containing a linear structure. The raw material composition of the polyimide resin (P19) is shown in Table 1.

[Synthesis Example 20] Synthesis of polyimide resin (P20)

In a dry nitrogen flow, 30.03 g (0.100 mol) of TDA-100 and 100 g of GBL were added to a three-necked flask, and the mixture was stirred and dissolved at 60°C. Subsequently, 0.44 g (0.004 mol) of MAP, 11.11 g (0.043 mol) of BAP, 16.36 g (0.043 mol) of BAHF, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P20). The polyimide resin (P20) has an alkyleneoxy skeleton represented by the formula (1). The alkyleneoxy equivalent of the polyimide resin (P20) is $6.4 \times 10^3$ g/mol. The raw material composition of the polyimide resin (P20) is shown in Table 1.

[Synthesis Example 21] Synthesis of polyimide resin (P21)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 7.75 g (0.030 mol) of BAP, 11.41 g (0.030 mol) of BAHF, and 10.00 g (0.010 mol) of RT-1000 were added, and the mixture was stirred at 60°C for 1 hour, then heated to 200°C, and stirred for 4 hours. The reaction solution was allowed to cool, affording a GBL solution of polyimide resin (P21). The polyimide resin (P21) has an alkyleneoxy skeleton represented by the formula (1). The alkyleneoxy equivalent of the polyimide resin (P21) is $5.8 \times 10^3$ g/mol. The raw material composition of the polyimide resin (P21) is shown in Table 1.

[Synthesis Example 22] Synthesis of polyimide resin (P22)

In a dry nitrogen flow, 30.03 g (0.100 mol) of TDA-100 and 100 g of GBL were added to a three-necked flask, and the mixture was stirred and dissolved at 60°C. Subsequently, 0.44 g (0.004 mol) of MAP, 5.49 g (0.015 mol) of 6FAP, 18.34 g (0.071 mol) of BAP, and 5.39 g (0.010 mol) of P1075 were added, and the mixture was stirred at 60°C for 1 hour, then heated to 200°C, and stirred for 4 hours. The reaction solution was allowed to cool, affording a GBL solution of polyimide resin (P22). The polyimide resin (P22) has a dimer acid derivative skeleton as an aliphatic hydrocarbon skeleton containing a linear structure. The raw material composition of the polyimide resin (P22) is shown in Table 1.

[Synthesis Example 23] Synthesis of polyimide resin (P23)

In a dry nitrogen flow, 30.03 g (0.100 mol) of TDA-100 and 100 g of GBL were added to a three-necked flask, and the mixture was stirred and dissolved at 60°C. Subsequently, 1.09 g (0.010 mol) of MAP, 1.83 g (0.005 mol) of 6FAP, 14.21 g (0.055 mol) of BAP, and 5.39 g (0.010 mol) of P1075 were added, and the mixture was stirred at 60°C for 1 hour, then heated to 200°C, and stirred for 4 hours. The reaction solution was allowed to cool, affording a GBL solution of polyimide resin (P23). The polyimide resin (P23) has a dimer acid derivative skeleton as an aliphatic hydrocarbon skeleton containing a linear structure. The raw material composition of the polyimide resin (P23) is shown in Table 1.

[Table 1]

| Polyimide resin (A) | Carboxylic acid derivative molar ratio A | Diamine molar ratio | | | | | | | | Monoamine molar ratio |
|---|---|---|---|---|---|---|---|---|---|---|
| | TDA-100 | 6FAP | BAP | BAHF | ABPS | P1075 | SiDA | RT-1000 | HMDA | MAP |
| P1 | 100 | 90 | - | - | - | - | - | - | - | 10 |

(continued)

| Polyimide resin (A) | Carboxylic acid derivative molar ratio A | Diamine molar ratio | | | | | | | | Monoamine molar ratio |
|---|---|---|---|---|---|---|---|---|---|---|
| | TDA-100 | 6FAP | BAP | BAHF | ABPS | P1075 | SiDA | RT-1000 | HMDA | MAP |
| P2 | 100 | 80 | - | - | - | 10 | - | - | - | 10 |
| P3 | 100 | 80 | - | - | - | - | 10 | - | - | 10 |
| P4 | 100 | 80 | - | - | - | - | - | 10 | - | 10 |
| P5 | 100 | 80 | - | - | - | - | - | - | 10 | 10 |
| P6 | 100 | 60 | - | - | - | 30 | - | - | - | 10 |
| P7 | 100 | 87 | - | - | - | 3 | - | - | - | 10 |
| P8 | 100 | 75 | - | - | - | 15 | - | - | - | 10 |
| P9 | 100 | 89 | - | - | - | - | - | 1 | - | 10 |
| P10 | 100 | 87 | - | - | - | - | - | 3 | - | 10 |
| P11 | 100 | 70 | - | - | - | - | - | 20 | - | 10 |
| P12 | 100 | 15 | 65 | - | - | - | - | 10 | - | 10 |
| P13 | 100 | 40 | 40 | - | - | - | - | 10 | - | 10 |
| P14 | 100 | 15 | - | 65 | - | - | - | 10 | - | 10 |
| P15 | 100 | 15 | - | - | 65 | - | - | 10 | - | 10 |
| P16 | 100 | - | 40 | - | 40 | - | - | 10 | - | 10 |
| P17 | 100 | - | - | 40 | 40 | - | - | 10 | - | 10 |
| P18 | 100 | - | 40 | 40 | - | - | - | 10 | - | 10 |
| P19 | 100 | 15 | 65 | - | - | 10 | - | - | - | 10 |
| P20 | 100 | - | 43 | 43 | - | - | - | 10 | - | 4 |
| P21 | 100 | - | 30 | 30 | - | - | - | 10 | - | 10 |
| P22 | 100 | 15 | 71 | - | - | 10 | - | - | - | 4 |
| P23 | 100 | 5 | 55 | - | - | 10 | - | - | - | 10 |

[Example 1]

A small amount of the GBL solution of polyimide (P3) was taken as the polyimide resin (A), placed in an aluminum cup having a known mass, the total mass was measured, and the value obtained by subtracting the mass of the aluminum cup from the total mass was taken as I. Subsequently, the total mass after removing the solvent by heating at 250°C for 1 hour was measured, and the value obtained by subtracting the mass of the aluminum cup from this total mass was taken as II. Referring to the solid concentration calculated by II/I, GBL was added to the GBL solution of polyimide (P3) to prepare a GBL solution to contain polyimide (P3) in an amount of 40% by mass, thereby affording a 40% by mass GBL solution of polyimide (P3).

Next, under yellow light, 62.5 g of the 40% by mass GBL solution of polyimide (P3), 30 g of YL-980 as the cationically polymerizable compound (B), and 1.7 g of CPI-310FG as the cationic polymerization initiator (C) were mixed, and the resulting mixture was subjected to pressure filtration using a filter having a particle retention size of 1 μm, affording a negative photosensitive resin composition. The storage stability, photosensitivity, resolution, exposure margin, residual stress, and water absorption of the negative photosensitive resin composition were evaluated in accordance with the evaluation methods (1) to (6). The evaluation results are shown in Table 8.

[Examples 2 to 51, Comparative Examples 1 to 3]

A 40% by mass GBL solution of a polyimide resin (A) was prepared in the same manner as in Example 1 except that a corresponding polyimide resin (A) shown in Tables 2 to 7 was used.

A negative photosensitive resin composition was prepared in the same manner as in Example 1 except that the 40% by mass GBL solution of the polyimide resin (A) was mixed with the cationically polymerizable compound (B), the cationic polymerization initiator (C), the methylol-based crosslinking agent (D), and other components in a corresponding composition shown in Tables 2 to 7.

For Examples 2 to 26 and Comparative Examples 1 to 3, the storage stability, photosensitivity, resolution, exposure margin, residual stress, and water absorption of the negative photosensitive resin composition were evaluated in accordance with the evaluation methods (1) to (6) described above. The evaluation results are shown in Tables 8 and 9.

In addition, for Examples 2, 7, and 27 to 51, the storage stability, photosensitivity, resolution, residual stress, water absorption, residue, and fluorine atom content of the negative photosensitive resin composition, and the organic deposit on a metal electrode were evaluated in accordance with the evaluation methods (1) to (3) and (5) to (10) described above. The results of evaluation are shown in Tables 10 and 11.

[Table 2]

| | Composition of photosensitive resin composition (added amount/g) | | | | | | | |
|---|---|---|---|---|---|---|---|---|
| | **40%** by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 1 | GBL solution of P3 (62.5) | CPI-310FG (1.7) | - | YL980 (30) | - | - | - | - |
| Example 2 | GBL solution of P4 (62.5) | CPI-310FG (1.7) | - | YL980 (30) | - | - | - | - |
| Example 3 | GBL solution of P5 (62.5) | CPI-310FG (1.7) | - | YL980 (30) | - | - | - | - |
| Example 4 | GBL solution of **P6** (62.5) | CPI-310FG (1.7) | - | YL980 (30) | - | - | - | - |
| Example 5 | GBL solution of P2 (62.5) | CPI-310FG (1.7) | - | - | - | CHDVE (30) | - | - |
| Example 6 | GBL solution of P7 (62.5) | CPI-310FG (1.7) | - | YL980 (30) | - | - | - | - |
| Example 7 | GBL solution of P2 (62.5) | CPI-310FG (1.7) | - | YL9BO (30) | - | - | - | - |
| Example 8 | GBL solution of P8 (62.5) | CPI-310FG (1.7) | - | YL980 (30) | - | - | - | - |
| Example 9 | GBL solution of P2 (62.5) | CPI-310FG (1.7) | - | - | OXT-191 (30) | - | - | - |

(continued)

| | Composition of photosensitive resin composition (added amount/g) | | | | | | | |
|---|---|---|---|---|---|---|---|---|
| | **40%** by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 10 | GBL solution of P2 (62.5) | CPI-310FG (1.7) | - | - | OXT-121 (30) | - | - | - |

[Table 3]

| | Composition of photosensitive resin composition (added amount/g) | | | | | | | |
|---|---|---|---|---|---|---|---|---|
| | 40% by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Cationically Epoxy | Oxetane | Vinyl ether | | |
| Example 11 | GBL solution of P2 (62.5) | CPI-310FG (1.7) | - | YL980 (15) | OXT121 (15) | - | - | - |
| Example 12 | GBL solution of P2 (62.5) | CPI-310FG (1.7) | - | PETG (30) | - | - | - | - |
| Example 13 | GBL solution of P2 (62.5) | CPI-310FG (1.7) | - | YL980 (15) PETG (15) | - | - | - | - |
| Example 14 | GBL solution of P2 (62.5) | CPI-310FG (1.7) | - | PETG (15) | OXT191 (15) | - | - | - |
| Example 15 | GBL solution of P2 (62.5) | CPI-310FG (1.7) | - | YL980 (15) | OXT191 (15) | - | - | - |
| Example 16 | GBL solution of P2 (62.5) | CPI-310FG (1.7) | - | PETG (24) | OXT121 (6) | - | - | - |
| Example 17 | GBL solution of P2 (62.5) | CPI-310FG (1.7) | - | PETG (15) | OXT121 (15) | - | - | - |
| Example 18 | GBL solution of P2 (62.5) | CPI-310FG (1.7) | - | PETG (15) | OXBP (15) | - | - | - |
| Example 19 | GBL solution of P2 (62.5) | CPI-310FG (1.7) | - | NPG (D) (15) | OXT121 (15) | - | - | - |
| Example 20 | GBL solution of P2 (62.5) | CPI-310FG (1.7) | - | PETG (20) | OXT121 (10) | - | - | - |

[Table 4]

| | composition of photosensitive resin composition (added amount/g) | | | | | | | |
|---|---|---|---|---|---|---|---|---|
| | 40% by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 21 | GBL solution of P2 (62.5) | CPI-310FG (1.7) | - | PETG (10) | OXT121 (20) | - | - | - |
| Example 22 | GBL solution of P2 (62.5) | CPI-310FG (1.7) | - | PETG (10) | OXT121 (10) OXBP (10) | - | - | - |
| Example 23 | GBL solution of P2 (62.5) | CPI-310FG (1.7) | - | NPG (D) (15) | OXT121 (15) | - | HMOM-HAP (2) | - |
| Example 24 | GBL solution of P2 (62.5) | WPI-116 (1.7) | - | NPG (D) (15) | OXT121 (15) | - | HM-HAP (2) | - |
| Example 25 | GBL solution of P2 (62.5) | CPI-310FG (1.7) | - | NPG (D) (15) | OXT121 (15) | - | HM-HAP (2) | - |
| Example 26 | GBL solution of P2 (62.5) | CPI-310FG (1.7) | - | PETG (10) | OXT121 (10) OXBP (10) | - | TM-BIP-A (2) | - |
| Example 27 | GBL solution of P9 (62.5) | CPI-310FG (1.7) | - | YL980 (30) | - | - | - | - |
| Example 28 | GBL solution of P10 (62.5) | CPI-310FG (1.7) | - | YL980 (30) | - | - | - | - |
| Example 29 | GBL solution of P11 (62.5) | CPI-310FG (1.7) | - | YL980 (30) | - | - | - | - |
| Example 30 | GBL solution of P12 (62.5) | CPI-310FG (1.7) | - | YL980 (30) | - | - | - | - |

[Table 5]

| | Composition of photosensitive resin composition (added amount/g) | | | | | | | |
|---|---|---|---|---|---|---|---|---|
| | 40% by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 31 | GBL solution of P13 (62.5) | CPI-310FG (1.7) | - | YL980 (30) | - | - | - | - |
| Example 32 | GBL solution of P14 (62.5) | CPI-310FG (1.7) | - | YL980 (30) | - | - | - | - |
| Example 33 | GBL solution of P15 (62.5) | CPI-310FG (1.7) | - | YL980 (30) | - | - | - | - |
| Example 34 | GBL solution of P16 (62.5) | CPI-310FG (1.7) | - | YL980 (30) | - | - | - | - |
| Example 35 | GBL solution of P17 (62.5) | CPI-310FG (1.7) | - | YL980 (30) | - | - | - | - |
| Example 36 | GBL solution of P18 (62.5) | CPI-310FG (1.7) | - | YL980 (30) | - | - | - | - |
| Example 37 | GBL solution of P19 (62.5) | CPI-310FG (1.7) | - | YL980 (30) | - | - | - | - |
| Example 38 | GBL solution of P20 (62.5) | CPI-310FG (1.7) | - | YL980 (30) | - | - | - | - |
| Example 39 | GBL solution of P21 (62.5) | CPI-310FG (1.7) | - | YL980 (30) | - | - | - | - |
| Example 40 | GBL solution of P22 (62.5) | CPI-310FG (1.7) | - | YL980 (30) | - | - | - | - |

[Table 6]

| | Composition of photosensitive resin composition (added amount/g) | | | | | | | |
|---|---|---|---|---|---|---|---|---|
| | **40%** by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 41 | GBL solution of P23 (62.5) | CPI-310FG (1.7) | - | YL980 (30) | - | - | - | - |

(continued)

| | Composition of photosensitive resin composition (added amount/g) | | | | | | | | |
|---|---|---|---|---|---|---|---|---|---|
| | **40%** by mass GBL solution of polyimide resin (A) | Initiator | | Crosslinking agent | | | | | |
| | | Cationic polymerization initiator (C) | Radical polymerization initiator | Cationically polymerizable compound (B) | | | Methylol-based crosslinking agent (D) | Acrylic monomer |
| | | | | Epoxy | Oxetane | Vinyl ether | | |
| Example 42 | GBL solution of P17 (62.5) | CPI-310FG (1.7) | - | - | OXT121 (30) | - | - | - |
| Example 43 | GBL solution of P17 (62.5) | CPI-310FG (1.7) | - | PETG (30) | - | - | - | - |
| Example 44 | GBL solution of P17 (62.5) | CPI-310FG (1.7) | - | PETG (24) | OXT121 (6) | - | - | - |
| Example 45 | GBL solution of P17 (62.5) | CPI-310FG (1.7) | - | PETG (10) | OXT121 (20) | - | - | - |
| Example 46 | GBL solution of P17 (62.5) | CPI-310FG (1.7) | - | PETG (10) | OXBP (20) | - | - | - |
| Example 47 | GBL solution of P17 (62.5) | CPI-310FG (1.7) | - | YL980 (10) | OXT121 (20) | - | - | - |

[Table 7]

| | Composition of photosensitive resin composition (added amount/g) | | | | | | | |
|---|---|---|---|---|---|---|---|---|
| | 40% by mass GBL solution of polyimide resin (A) | Initiator | | Crosslinking agent | | | | |
| | | Cationic polymerization initiator (C) | Radical polymerization initiator | Cationically polymerizable compound (B) | | | Methylol-based crosslinking agent (D) agent | Acrylic monomer |
| | | | | Epoxy | Oxetane | Vinyl ether | | |
| Example 48 | GBL solution of P17 (100) | CPI-310FG (1.7) | - | - | YL980 (30) | - | - | - |
| Example 49 | GBL solution of P17 (37.5) | CPI-310FG (1.7) | - | - | YL980 (30) | - | - | - |
| Example 50 | GBL solution of P17 (100) | CPI-310FG (1.7) | - | PETG (10) | OXT121 (20) | - | - | - |
| Example 51 | GBL solution of P17 (37.5) | CPI-310FG (1.7) | - | PETG (10) | OXT121 (20) | - | - | - |
| Comparative Example 1 | GBL solution of P1 (62.5) | CPI-310FG (1.7) | - | YL980 (30) | - | - | - | - |
| Comparative Example 2 | GBL solution of P1 (62.5) | CPI-310FG (1.7) | - | - | - | CHDVE (30) | - | - |
| Comparative Example 3 | GBL solution of P2 (62.5) | - | OXE-02 (5) | - | - | - | - | M-315 (30) |

[Table 8]

| | Evaluation results | | | | | | | |
|---|---|---|---|---|---|---|---|---|
| | Storage stability | Photosensitivity | Resolution | Exposure margin | Residual stress | | Water absorption | |
| | Determination | Exposure energy (mJ/cm$^2$) | Resolution (μm) | Determination | Residual stress after drying (MPa) | Determination | Amount of change in residual stress (MPa) | Determination |
| Example 1 | D | 1000 | 20 | C | 38 | D | 24 | D |
| Example 2 | A | 1500 | 20 | C | 32 | C | 21 | D |
| Example 3 | A | 1000 | 20 | C | 35 | C | 25 | D |
| Example 4 | A | 1500 | 30 | D | 26 | B | 16 | C |
| Example 5 | A | 2000 | 20 | D | 39 | D | 24 | D |
| Example 6 | A | 1000 | 20 | C | 37 | D | 23 | D |
| Example 7 | A | 1000 | 20 | C | 34 | C | 21 | D |
| Example 8 | A | 1000 | 20 | C | 30 | B | 19 | C |
| Example 9 | B | 300 | 10 | C | 35 | C | 13 | B |
| Example 10 | A | 300 | 30 | D | 22 | A | 7 | A |
| Example 11 | A | 500 | 20 | c | 26 | B | 13 | B |
| Example 12 | B | 500 | 5 | A | 33 | C | 25 | D |
| Example 13 | A | 700 | 5 | B | 31 | C | 23 | D |
| Example 14 | c | 300 | 5 | C | 33 | C | 17 | C |
| Example 15 | B | 500 | 10 | C | 34 | C | 15 | B |

[Table 9]

| | Evaluation results | | | | | | | |
|---|---|---|---|---|---|---|---|---|
| | Storage stability | Photosensitivity | Resolution | Exposure margin | Residual stress | | Water absorption | |
| | Determination | Exposure energy (mJ/cm$^2$) | Resolution (μm) | Determination | Residual stress after drying (MPa) | Determination | Amount of change in residual stress (MPa) | Determination |
| Example 16 | B | 300 | 5 | C | 31 | C | 25 | D |
| Example 17 | B | 300 | 5 | C | 27 | B | 12 | B |
| Example 18 | B | 300 | 5 | C | 28 | B | 13 | B |
| Example 19 | A | 300 | 10 | C | 23 | A | 8 | A |
| Example 20 | B | 300 | 5 | C | 29 | B | 14 | B |
| Example 21 | A | 300 | 5 | C | 24 | A | 10 | A |
| Example 22 | A | 300 | 10 | C | 24 | A | 9 | A |
| Example 23 | A | 500 | 5 | B | 27 | B | 9 | A |
| Example 24 | A | 1500 | 10 | B | 28 | B | 15 | B |
| Example 25 | A | 300 | 5 | A | 24 | A | 10 | A |
| Example 26 | A | 300 | 5 | A | 25 | A | 10 | A |
| Comparative Example 1 | A | 1000 | 20 | C | 41 | E | 28 | E |
| Comparative Example 2 | A | 2000 | 20 | D | 42 | E | 26 | E |
| Comparative Example 3 | D | 300 | 30 | E | 44 | E | 23 | D |

[Table 10-1]

| | Evaluation results | | | | |
|---|---|---|---|---|---|
| | Storage stability | Photosensitivity | Resolution | Residue | Heat resistance |
| | Determination | Exposure energy (mJ/cm$^2$) | Resolution (μm) | Determination | Determination |
| Example 2 | A | 1500 | 20 | B | B |
| Example 7 | A | 1000 | 20 | D | B |
| Example 27 | A | 1000 | 20 | C | B |
| Example 28 | A | 1500 | 20 | B | B |
| Example 29 | A | 2000 | 20 | B | B |
| Example 30 | A | 1500 | 20 | c | A |
| Example 31 | A | 1500 | 20 | C | A |
| Example 32 | A | 1500 | 20 | A | A |
| Example 33 | A | 1500 | 20 | C | A |
| Example 34 | A | 1500 | 20 | C | A |
| Example 35 | A | 1500 | 20 | A | A |
| Example 36 | A | 1500 | 20 | A | A |
| Example 37 | A | 1000 | 20 | D | A |
| Example 38 | A | 2500 | 30 | C | A |

[Table 10-2]

| | Evaluation results | | | | | |
|---|---|---|---|---|---|---|
| | Residual stress | | Water absorption | | Fluorine atom content (% by mass) | Organic deposit |
| | Residual stress after drying (MPa) | Determination | Amount of change in residual stress (MPa) | Determination | | Determination |
| Example 2 | 32 | C | 21 | D | 6.9 | c |
| Example 7 | 34 | C | 21 | D | 7.3 | C |
| Example 27 | 37 | D | 25 | D | 8.2 | c |
| Example 28 | 34 | C | 24 | D | 7.9 | C |
| Example 29 | 30 | B | 20 | C | 5,7 | C |
| Example 30 | 34 | C | 23 | D | 2.2 | B |
| Example 31 | 33 | C | 22 | D | 4.1 | C |
| Example 32 | 35 | C | 20 | C | 2.0 | A |
| Example 33 | 33 | C | 25 | D | 2.1 | B |
| Example 34 | 34 | C | 25 | D | 0.9 | A |
| Example 35 | 34 | C | 22 | D | 0.9 | A |
| Example 36 | 34 | C | 21 | D | 0.9 | A |
| Example 37 | 34 | C | 24 | D | 2.3 | B |
| Example 38 | 35 | D | 21 | D | 0.9 | A |

[Table 11-1]

| | Evaluation results | | | | |
|---|---|---|---|---|---|
| | Storage stability | Photosensitivity | Resolution | Residue | Heat resistance |
| | Determination | Exposure energy (mJ/cm$^2$) | Resolution (μm) | Determination | Determination |
| Example 39 | A | 1500 | 20 | A | C |
| Example 40 | A | 2000 | 30 | E | A |
| Example 41 | A | 1000 | 20 | D | C |
| Example 42 | A | 500 | 30 | B | A |
| Example 43 | B | 700 | 5 | A | A |
| Example 44 | B | 500 | 5 | A | A |
| Example 45 | B | 500 | 5 | A | A |
| Example 46 | B | 500 | 5 | A | A |
| Example 47 | A | 500 | 20 | A | A |
| Example 48 | D | 2000 | 20 | A | A |
| Example 49 | A | 1500 | 20 | A | B |
| Example 50 | D | 700 | 5 | A | A |
| Example 51 | A | 500 | 5 | A | B |

[Table 11-2]

| | Evaluation results | | | | | |
|---|---|---|---|---|---|---|
| | Residual stress | | Water absorption | | Fluorine atom content (% by mass) | Organic deposit |
| | Residual stress after drying (MPa) | Determination | Amount of change in residual stress (MPa) | Determination | | Determination |
| Example 39 | 33 | C | 22 | D | 0.9 | A |
| Example 40 | 37 | D | 24 | D | 2.2 | B |
| Example 41 | 34 | C | 23 | D | 1.4 | A |
| Example 42 | 24 | A | 8 | A | 0.9 | A |
| Example 43 | 35 | D | 25 | D | 0.9 | A |
| Example 44 | 33 | C | 24 | D | 0.9 | A |
| Example 45 | 24 | A | 10 | A | 0.9 | A |
| Example 46 | 25 | A | 9 | A | 0.9 | A |
| Example 47 | 26 | B | 13 | B | 0.9 | A |
| Example 48 | 38 | D | 24 | D | 0.7 | A |
| Example 49 | 32 | C | 21 | D | 1.1 | A |
| Example 50 | 26 | B | 12 | B | 0.7 | A |
| Example 51 | 23 | A | 9 | A | 1.1 | A |

## Claims

**1.** A negative photosensitive resin composition comprising: a polyimide resin (A) containing one or more skeletons selected from the group consisting of an alkyleneoxy skeleton, a siloxane skeleton, and an aliphatic hydrocarbon

skeleton containing a linear structure; a cationically polymerizable compound (B); and a cationic polymerization initiator (C).

2. The negative photosensitive resin composition according to claim 1, wherein the polyimide resin (A) contains an aliphatic hydrocarbon skeleton containing a linear structure, and the aliphatic hydrocarbon skeleton containing a linear structure contains a dimer acid derivative skeleton.

3. The negative photosensitive resin composition according to claim 2, wherein the dimer acid derivative skeleton contains a dimer diamine skeleton, and a content of a dimer diamine residue in a total amount of 100 mol% of all diamine residues in the polyimide resin (A) is 3 mol% or more and 20 mol% or less.

4. The negative photosensitive resin composition according to claim 1, wherein the polyimide resin (A) contains an alkyleneoxy skeleton, and

the alkyleneoxy skeleton is a skeleton represented by formula (1):

[Chemical Formula 1]

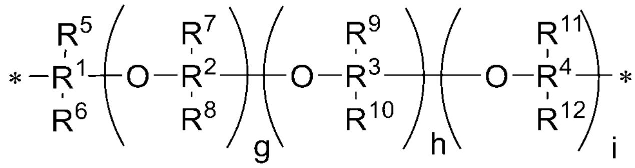 (1)

in the formula (1), $R^1$ to $R^4$ each independently represent an alkylene group having 1 to 6 carbon atoms; $R^5$ to $R^{12}$ each independently represent a hydrogen atom, a fluorine atom, or an alkyl group having 1 to 6 carbon atoms; parenthesized structures are different from each other; g, h, and i each independently represent an integer of 0 to 35, and $g + h + i > 0$; each symbol * represents a bonding site.

5. The negative photosensitive resin composition according to any one of claims 1 to 4, wherein a content of fluorine atoms in 100% by mass of the negative photosensitive resin composition excluding a solvent is 0.0% by mass or more and 3.0% by mass or less.

6. The negative photosensitive resin composition according to any one of claims 1 to 4, wherein a ratio Y/X of an amount Y (mol) of all diamine residues to an amount X (mol) of all carboxylic acid residues contained in the polyimide resin (A) is 0.80 to 0.95.

7. The negative photosensitive resin composition according to any one of claims 1 to 4, wherein the cationically polymerizable compound (B) contains an epoxy compound and/or an oxetane compound.

8. The negative photosensitive resin composition according to claim 7, wherein the oxetane compound contains an oxetane compound (B1) represented by formula (8):

[Chemical Formula 2]

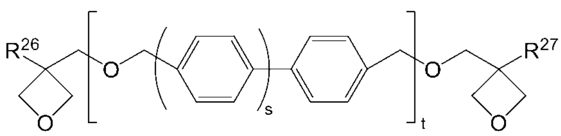 (8)

in the formula (8), s and t each independently represent an integer of 0 to 6, and $R^{26}$ and $R^{27}$ each independently represent a monovalent organic group having 1 to 5 carbon atoms.

9. The negative photosensitive resin composition according to claim 7, wherein the epoxy compound contains an epoxy compound (B2) represented by formula (9):

[Chemical Formula 3]

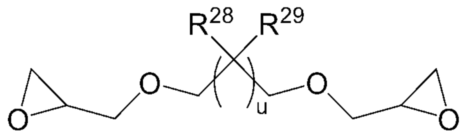

(9)

in the formula (9), u represents an integer of 1 to 5, and $R^{28}$ and $R^{29}$ each independently represent a hydrogen atom, a methyl group, or a group represented by formula (10) :

[Chemical Formula 4]

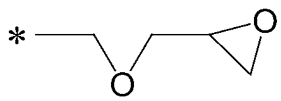

(10)

in the formula (10), the symbol * represents a bonding site.

**10.** The negative photosensitive resin composition according to claim 7, wherein the cationically polymerizable compound (B) contains the epoxy compound and the oxetane compound, and an amount of the epoxy compound based on 100 parts by mass of the oxetane compound is 10 to 250 parts by mass.

**11.** The negative photosensitive resin composition according to any one of claims 1 to 4, further comprising a methylol-based crosslinking agent (D).

**12.** The negative photosensitive resin composition according to claim 11, wherein the methylol-based crosslinking agent (D) contains a compound (D1) represented by formula (11):

[Chemical Formula 5]

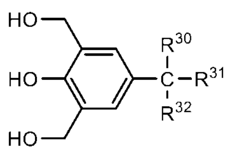

(11)

in the formula (11), $R^{30}$, $R^{31}$ and $R^{32}$ each independently represent a hydrogen atom, a methyl group, or a group represented by formula (12):

[Chemical Formula 6]

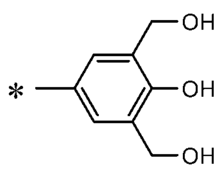

(12)

in the formula (12), the symbol * represents a bonding site.

**13.** The negative photosensitive resin composition according to any one of claims 1 to 4, wherein the cationic polymerization initiator (C) contains a sulfonium salt containing at least one selected from the group consisting of a borate ion, a phosphate ion, and a gallate ion as a counter anion.

**14.** A cured product derived from the negative photosensitive resin composition according to any one of claims 1 to 4.

**15.** A method for producing a cured product, the method comprising:

a step of applying the negative photosensitive resin composition according to any one of claims 1 to 4 onto a substrate, and drying the negative photosensitive resin composition to form a photosensitive resin film on the substrate;
a step of exposing the photosensitive resin film to light;
a step of removing an unexposed portion of the photosensitive resin film with an alkali aqueous solution to develop the photosensitive resin film; and
a step of heat-treating the developed photosensitive resin film to form a cured product.

**16.** A hollow structure comprising a support material containing the cured product according to claim 14.

**17.** An electronic component comprising the cured product according to claim 14.

**18.** The electronic component according to claim 17, wherein the cured product has a residual stress under a dry nitrogen atmosphere of 15 to 35 MPa.

**19.** An acoustic wave filter comprising the cured product according to claim 14, wherein the cured product has a residual stress under a dry nitrogen atmosphere of 15 to 35 MPa.

**INTERNATIONAL SEARCH REPORT**

International application No. **PCT/JP2024/011242**

**A. CLASSIFICATION OF SUBJECT MATTER**

***G03F 7/037***(2006.01)i; ***C08G 59/22***(2006.01)i; ***C08G 73/10***(2006.01)i; ***C08K 5/1515***(2006.01)i; ***C08K 5/1525***(2006.01)i; ***C08L 79/08***(2006.01)i; ***G03F 7/004***(2006.01)i; ***G03F 7/20***(2006.01)i
FI: G03F7/037 501; C08L79/08; C08K5/1515; C08K5/1525; C08G73/10; C08G59/22; G03F7/004 501; G03F7/004 503Z; G03F7/20 521

According to International Patent Classification (IPC) or to both national classification and IPC

**B. FIELDS SEARCHED**

Minimum documentation searched (classification system followed by classification symbols)

G03F7/037; C08G59/22; C08G73/10; C08K5/1515; C08K5/1525; C08L79/08; G03F7/004; G03F7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2022-135945 A (TORAY IND., INC.) 15 September 2022 (2022-09-15) claims | 1-19 |

☐ Further documents are listed in the continuation of Box C.

☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 April 2024** | **04 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/011242**

| Patent document cited in search report | Publication date (day/month/year) | Patent family member(s) | Publication date (day/month/year) |
|---|---|---|---|
| JP 2022-135945 A | 15 September 2022 | TW 202332712 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008007764 A
- JP 2019038964 A